(19) Europäisches Patentamt
European Patent Office
Office européen des brevets

(11) **EP 3 213 033 B1**

(12) **FASCICULE DE BREVET EUROPEEN**

(45) Date de publication et mention
de la délivrance du brevet:
**22.08.2018 Bulletin 2018/34**

(21) Numéro de dépôt: **15787940.4**

(22) Date de dépôt: **23.10.2015**

(51) Int Cl.:
***G01C 21/16*** *(2006.01)*

(86) Numéro de dépôt international:
**PCT/EP2015/074570**

(87) Numéro de publication internationale:
**WO 2016/066538 (06.05.2016 Gazette 2016/18)**

(54) **PROCÉDÉ D'ESTIMATION D'UN ÉTAT DE NAVIGATION CONTRAINT EN OBSERVABILITÉ**

VERFAHREN ZUR SCHÄTZUNG EINES NAVIGATIONSZUSTANDS, DER IN BEZUG AUF BEOBACHTBARKEIT EINGESCHRÄNKT IST

METHOD OF ESTIMATING A NAVIGATION STATE CONSTRAINED IN TERMS OF OBSERVABILITY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.10.2014 FR 1460412**

(43) Date de publication de la demande:
**06.09.2017 Bulletin 2017/36**

(73) Titulaire: **Safran Electronics & Defense**
**92100 Boulogne-Billancourt (FR)**

(72) Inventeur: **PERROT, Thierry**
**F-92100 Boulogne-Billancourt (FR)**

(74) Mandataire: **Regimbeau**
**20, rue de Chazelles**
**75847 Paris Cedex 17 (FR)**

(56) Documents cités:
**WO-A1-2014/130854**

• **HUANG G P ET AL: "Analysis and improvement of the consistency of extended Kalman filter based SLAM", 2008 IEEE INTERNATIONAL CONFERENCE ON ROBOTICS AND AUTOMATION. THE HALF-DAY WORKSHOP ON: TOWARDS AUTONOMOUS AGRICULTURE OF TOMORROW, IEEE - PISCATAWAY, NJ, USA, PISCATAWAY, NJ, USA, 19 mai 2008 (2008-05-19), pages 473-479, XP031340196, ISBN: 978-1-4244-1646-2**

**Description**

DOMAINE GENERAL

L'invention se rapporte au domaine des centrales inertielles de navigation.

L'invention concerne plus particulièrement un procédé d'estimation de l'état de navigation d'un porteur mobile utilisant un filtre de Kalman étendu (généralement abrégé EKF dans la littérature), ainsi qu'une centrale inertielle adaptée pour mettre en oeuvre un tel procédé.

ETAT DE L'ART

Une centrale inertielle de navigation est un appareil destiné à fournir en temps réel des informations sur l'état d'un porteur : sa position, sa vitesse, son orientation, etc. Ces informations peuvent être utilisées pour piloter le porteur.

Une solution connue pour les estimer consiste à mettre en oeuvre dans une centrale inertielle un filtre de Kalman étendu qui fournit un état estimé du porteur en fusionnant des données de capteurs inertiels (accéléromètres, gyromètres), et de capteurs non inertiels adaptés au type de porteur (odomètre, baro-altimètre, radar Doppler, récepteur GPS, etc). Les données inertielles jouent le rôle de commandes, et les données non inertielles celui d'observations.

Le filtre de Kalman est un algorithme comprenant typiquement une étape de prédiction et une étape de mise à jour répétées dans le temps : l'étape de prédiction calcule un état courant à partir d'un état précédent et de commandes d'entrée; l'étape de mise à jour affine l'état courant à l'aide d'observations. Les calculs de prédiction sont basés sur une équation de propagation modélisant la dynamique de l'état en fonction de l'état et de la commande. Les calculs de mise à jour sont basés sur une équation d'observation modélisant l'observation en fonction de l'état.

Dans le filtre de Kalman, les équations de propagation et d'observation sont linéaires et prennent la forme de matrices ne dépendant pas de l'état estimé.

Dans le filtre de Kalman étendu, l'une au moins de ces fonctions est non linéaire. La fusion de données est obtenue en linéarisant ces fonctions aux étapes de propagation et de mise à jour. Les calculs sont donc effectués en utilisant des matrices qui dépendent de l'état estimé.

Le filtre de Kalman étendu peut alors être considéré comme un algorithme effectuant d'une part des calculs non linéaires et d'autre part des calculs linéaires effectués dans un filtre de Kalman à l'intérieur du filtre de Kalman étendu. L'état prédit par l'équation de propagation non linéaire sera dans la suite nommé « état global ». L'état estimé par le filtre de Kalman sera nommé « état linéarisé ». L'état global peut être corrigé par les informations portées par l'état linéarisé lors d'étapes de recalage.

Un filtre de Kalman (étendu ou non) calcule en outre une marge d'erreur associée à l'estimation de l'état en tenant compte d'une estimation de l'erreur statistique due à de nombreux facteurs tels que les erreurs initiales et les bruits des capteurs inertiels utilisés. L'erreur statistique à un instant donné peut se représenter sous forme d'un nuage de points dans l'espace d'état, chaque point correspondant à une réalisation possible. Pour estimer cette marge d'erreur, la centrale dispose d'un modèle statistique gaussien de l'erreur caractérisé à chaque instant par une moyenne nulle, et une matrice de covariance. Cette dernière définit l'enveloppe d'un volume ellipsoïdal dans l'espace d'état, centré sur l'erreur nulle, et contenant 99,97% des erreurs estimées dans chaque direction de l'espace d'état. Cette enveloppe est par la suite dénommée « enveloppe 3 sigma ».

La vraie loi statistique d'erreurs est inconnue et caractérisée par une autre enveloppe 3 sigma. En général, cette enveloppe n'est pas centrée sur zéro et sa forme est non ellipsoïdale.

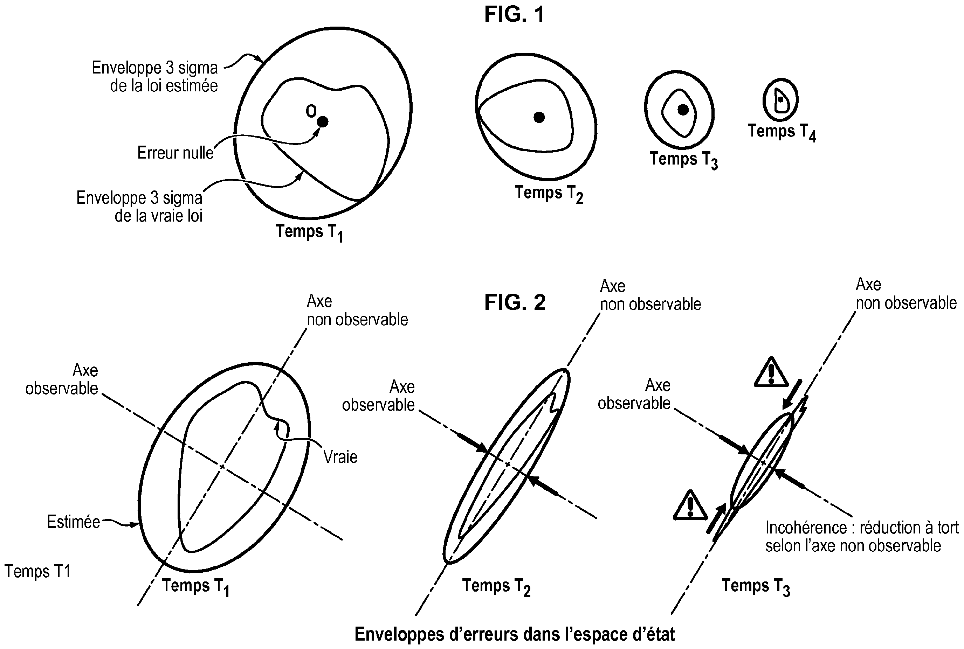

La **figure 1** représente l'évolution d'une enveloppe 3 sigma estimée et une enveloppe 3 sigma vraie à différentes itérations du filtre de Kalman. L'enveloppe 3 sigma vraie doit être contenue dans l'enveloppe 3 sigma estimée. Ceci constitue un critère de cohérence à respecter à tout instant et pour toutes les réalisations des variables aléatoires du système.

En général, le filtre de Kalman améliore au moyen des observations son estimation dans le temps, et les enveloppes 3 sigma ont tendance à s'aplatir le long de certains axes de l'espace d'état dits « observables », comme représenté en **figure 2.** Les axes qui sont orthogonaux à ces derniers sont dits « non observables ». L'enveloppe 3 sigma estimée prend alors une forme allongée selon les axes non observables, ce qui crée des corrélations entre les erreurs estimées.

Bien que l'imperfection du modèle utilisé par le filtre puisse jouer une part importante, il a été constaté que les non linéarités et les bruits du système empêchent souvent le critère de cohérence décrit ci-dessus d'être respecté lorsqu'un filtre de Kalman étendu est utilisé (par exemple, au temps T3 de la figure 2, l'enveloppe 3 sigma vraie n'est plus localisée à l'intérieur de l'enveloppe 3 sigma estimée le long d'un axe non observable).

Sur le long terme, ces incohérences peuvent devenir importantes et se propager aux autres axes de l'espace vectoriel de l'état à estimer.

Ces incohérences n'apparaissent généralement que dans des conditions particulières dépendant par exemple de la trajectoire du porteur et des conditions initiales. Ces conditions sont propres à l'observation et peuvent être très difficiles à prévoir. Elles sont d'autant plus fortes que l'observation est non linéaire.

La cause des incohérences est connue : l'étape de linéarisation, inhérente à un filtre de Kalman étendu, est bruitée par les erreurs d'estimation. En effet, cette linéarisation est effectuée à la dernière estimée produite par le filtre, estimée qui est par définition une donnée imprécise. Les modifications du second ordre produites sur les fonctions linéarisées par ce bruit d'estimation modifient alors les observations et sont la cause des incohérences.

Dans un premier cas, une variable observable peut être considérée par le filtre non observable mais ce cas est très improbable; et dans un deuxième cas, une variable non observable peut être considérée observable par le filtre. Cela réduit l'enveloppe 3 sigma estimée le long des axes non observables alors qu'elle devrait conserver sa valeur initiale. Or, cela ne réduit pas le nuage d'erreur vrai le long de ces mêmes axes puisque ces derniers sont réellement non observables. Une part de plus en plus importante du nuage d'erreur vrai risque alors de ne plus se trouver à l'intérieur de l'enveloppe 3 sigma estimée dès que celle-ci commence à se réduire. Les conséquences de cette incohérence peuvent être importantes et dépendent de l'enveloppe initiale de long des axes non observables en défaut.

Une solution de l'état de l'art permettant dans la plupart des cas de compenser la réduction de l'enveloppe 3 sigma estimée consiste à appliquer un bruit de modèle. L'algorithme EKF comporte en effet une opération consistant à augmenter la covariance en phase de prédiction à l'aide d'une matrice de bruits de modèles afin de tenir compte des variables et leur dynamique qui n'ont pas été modélisées dans le filtre. Dans ce problème de cohérence, la matrice de bruit est détournée de sa fonction car la réduction de l'enveloppe estimée n'est pas due à un problème de modélisation mais à un problème d'observabilité. De plus, pour des raisons d'architecture et de précision numérique de calcul, les bruits sont souvent appliqués sur la diagonale de la matrice de bruits de modèle : Tout comme la matrice de covariance, la diagonale de cette matrice correspond aux composantes de l'état linéarisé suivies par le filtre. En conséquence, le bruit n'est pas appliqué uniquement dans la direction des axes non observables. Il en résulte que le problème de cohérence risque de ne pas être totalement résolu, et que de plus cela nuit à la précision des estimations.

En effet, le bruit appliqué comporte une projection sur des axes non observables et une projection sur des axes observables, ces projections pouvant évoluer au cours du temps selon l'évolution des axes non observables. Plus la projection selon les axes observables est grande, et plus la valeur asymptotique de l'erreur est grande selon ces directions, et donc moins la précision des estimations est bonne.

La valeur du bruit à appliquer quant à elle n'est pas connue. Une valeur empirique est choisie, généralement grande afin de tenir compte de tous les cas connus posant problème. Cela aggrave le problème de la précision.

D'autre part, comme le bruit de modèle n'est pas appliqué dans la bonne direction, l'enveloppe estimée s'allonge selon une direction qui s'éloigne de l'axe non observable vrai. En conséquence, cette enveloppe ellipsoïdale, qui devient certes plus importante selon ses axes principaux, risque de ne plus recouvrir le nuage d'erreurs vraies. Il risque donc de subsister une incohérence.

Le problème d'observabilité est donc traité selon l'état de l'art par une solution qui ne résout pas complètement le problème, et qui de plus nuit à la précision des estimations.

On connaît par ailleurs du document WO 2014/130854 un procédé d'estimation d'un état utilisant un filtre de Kalman étendu EKF. Ce filtre EKF fait l'objet de contraintes d'observabilité; la matrice de transition et la matrice d'observation utilisées par ce filtre EKF font l'objet d'un ajustement.

PRESENTATION DE L'INVENTION

L'invention vise à estimer l'état global d'un porteur mobile régi par un modèle non-linéaire, tout en minimisant l'apparition des incohérences définies en introduction.

Il est dès lors proposé un procédé d'estimation d'un état de navigation à plusieurs variables d'un porteur mobile selon la méthode du filtre de Kalman étendu, comprenant les étapes de :

- acquisition de mesures d'au moins une des variables,
- filtrage de Kalman étendu produisant un état estimé courant et une matrice de covariance délimitant dans l'espace de l'état de navigation une région d'erreurs, à partir d'un état estimé précédent, d'une matrice d'observation, d'une matrice de transition et des mesures acquises,

le procédé étant caractérisé en ce qu'il comprend une étape d'ajustement de la matrice de transition et de la matrice d'observation avant leur utilisation dans le filtrage de Kalman étendu, de sorte que les matrices ajustées vérifient une condition d'observabilité qui dépend d'au moins une des variables de l'état du porteur, la condition d'observabilité étant adaptée pour empêcher le filtre de Kalman de réduire la dimension de la région le long d'au moins un axe non-observable de l'espace d'état,

dans lequel la condition d'observabilité à vérifier par les matrices de transition et d'observation ajustées est la nullité du noyau d'une matrice d'observabilité qui leur est associée, et

dans lequel l'ajustement comprend les étapes de :

- calcul d'au moins une base primaire de vecteurs non-observables à partir de l'état estimé précédent,
- pour chaque matrice à ajuster, calcul d'au moins un écart matriciel associé à la matrice à partir de la base primaire de vecteurs,

décalage de chaque matrice à ajuster selon l'écart matriciel qui lui est associé de sorte à vérifier la condition d'observabilité.

Le procédé selon l'invention permet non seulement d'améliorer la cohérence des estimations mais permet en outre d'améliorer la précision des estimations, car la part de bruits de modèle utilisée selon l'état de l'art pour résoudre les problèmes d'observabilité peut être annulée.

De plus, ce procédé ne modifie que très peu l'architecture logicielle du filtre EKF, et peut être mis en oeuvre sous forme d'une mise à jour logicielle légère sur des matériels déjà en opération. Cette mise à jour consiste en l'ajout d'une fonction d'ajustement de 2 matrices, et en une réduction des réglages de bruits de modèle.

L'invention peut également être complétée par les caractéristiques suivantes, prises seules ou en une quelconque de leurs combinaisons techniquement possibles.

L'étape de filtrage de Kalman étendu peut comprendre les sous-étapes de :

- propagation de l'état estimé précédent en un état prédit au moyen de la matrice de transition ajustée,
- linéarisation en l'état prédit d'un modèle non-linéaire pour produire la matrice d'observation avant ajustement,
- ajustement de la matrice d'observation produite par linéarisation.

Le fait de mettre en oeuvre la linéarisation après l'étape de propagation permet de faire sorte que cette linéarisation soit effectuée en un point de l'espace vectoriel plus vraisemblable : l'état prédit produit par l'étape de propagation. Dès lors, l'ajustement de la matrice d'observation tient compte de cette propagation, et fournit des résultats plus précis que dans le cas où la linéarisation est mise en oeuvre avant l'étape de propagation, en l'état estimé précédent.

L'ajustement peut en outre comprendre une étape d'orthogonalisation de la base primaire en une base secondaire de vecteurs, celle-ci étant mémorisée d'un cycle à l'autre, et l'écart matriciel associé à la matrice d'observation étant calculé à partir de la base secondaire de vecteurs.

L'écart matriciel associé à la matrice d'observation peut être la somme de plusieurs écarts matriciels indépendants, chaque écart matriciel étant calculé à partir d'un vecteur de la base secondaire qui lui est propre.

Les étapes du procédé peuvent être répétées dans des cycles successifs. Un cycle donné, dit cycle courant, peut alors comprendre les étapes de:

- mémorisation de la base secondaire de vecteurs et de coefficients d'orthogonalisation qui sont également produits par l'étape d'orthogonalisation, et
- transformation de la base primaire de vecteurs en une base tertiaire de vecteurs au moyen de coefficients d'orthogonalisation mémorisés au cours d'un cycle précédent,
- l'écart matriciel associé à la matrice de transition étant mis en oeuvre à partir d'une base secondaire mémorisée au cours du cycle précédent et de la base tertiaire calculée au cours du cycle courant.

L'écart matriciel associé à la matrice de transition peut en outre être la somme de plusieurs écarts matriciels élémentaires indépendants, chaque écart matriciel étant calculé à partir d'un vecteur secondaire de la base secondaire mémorisée au cours du cycle précédent et d'un vecteur tertiaire de la base tertiaire calculée au cours du cycle courant, les vecteurs secondaire et tertiaire étant propres à l'écart matriciel élémentaire.

Pour au moins une matrice à ajuster, on peut en outre calculer :

- une pluralité d'écarts matriciels candidats, chaque écart matriciel candidat étant calculé à partir d'une base primaire de vecteurs non-observables respective, et
- une pluralité de métriques, chaque métrique étant représentative d'une amplitude d'ajustement induite par un écart matriciel candidat respectif, l'étape de décalage de la matrice à ajuster étant mise en oeuvre selon un écart matriciel élu parmi les écarts matriciels candidats en fonction des métriques calculées.

L'écart matriciel élu peut être l'écart matriciel candidat associé à la métrique représentative de l'amplitude d'ajustement la plus faible.

Le décalage peut n'être mis en oeuvre que si la métrique de l'écart matriciel élu est inférieure à un seuil prédéterminé.

Selon un autre aspect de l'invention, il est proposé une centrale inertielle comprenant une pluralité de capteurs et un module d'estimation configuré pour estimer un état de navigation de la centrale inertielle à plusieurs variables par mise en oeuvre du procédé selon le premier aspect de l'invention.

DESCRIPTION DES FIGURES

D'autres caractéristiques, buts et avantages de l'invention ressortiront de la description qui suit, qui est purement illustrative et non limitative, et qui doit être lue en regard des dessins annexés sur lesquels :

- Les figures 1 et 2, déjà discutées, représentent deux évolutions d'enveloppes 3 sigma au cours du temps, au cours de la mise en oeuvre d'un filtre de Kalman étendu.

- La figure 3 représente schématiquement un porteur embarquant une centrale inertielle selon un mode de réalisation de l'invention.

- La figure 4 est le schéma fonctionnel d'un estimateur selon un mode de réalisation.

- La figure 5 est le schéma fonctionnel d'un bloc de linéarisation et d'ajustement compris dans l'estimateur de la figure 2.

- La figure 6 est le schéma fonctionnel d'un sous-bloc représenté sur la figure 5.

- La figure 7 illustre une justification géométrique de l'ajustement de matrices utilisées par le filtre de Kalman.

- La figure 8 représente un flux des données correspondant à la mise en oeuvre des étapes illustrées sur la figure 3.

Sur l'ensemble des figures, les éléments similaires portent des références identiques.

DESCRIPTION DETAILLEE DE L'INVENTION

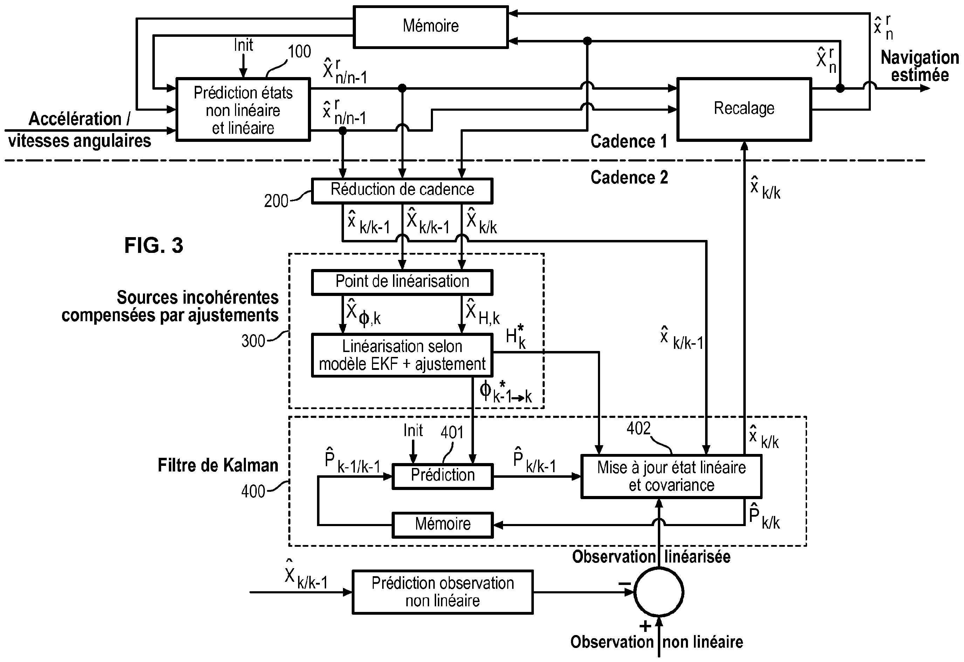

En référence à la **figure 3,** une centrale inertielle IN est embarquée sur un porteur mobile P, tel qu'un véhicule terrestre, un hélicoptère, un avion, etc.
La centrale inertielle IN comporte plusieurs parties : des capteurs inertiels CI, des capteurs complémentaires CC, et des moyens E pour mettre en oeuvre des calculs d'estimation. Ces parties peuvent être physiquement séparées les unes des autres.
Les capteurs inertiels CI sont typiquement des accéléromètres et/ou des gyromètres mesurant respectivement des forces spécifiques et des vitesses de rotation que subit le porteur par rapport à un référentiel inertiel. La force spécifique correspond à l'accélération d'origine non gravitationnelle. Lorsque ces capteurs sont fixes par rapport au porteur, la centrale est dite de type « strap down».
Les capteurs complémentaires CC sont variables selon le type de porteur, sa dynamique, et l'application visée. Les centrales inertielles utilisent typiquement un récepteur GNSS (GPS par exemple). Pour un véhicule terrestre, il s'agit également d'un ou de plusieurs odomètres. Pour un bateau, il peut s'agir d'un « loch », donnant la vitesse du bateau par rapport à celle de l'eau ou du fond marin. Les caméras forment un autre exemple de capteurs.
Les moyens d'estimation E de navigation seront par la suite désignés sous le terme « estimateur ».
Les données de sortie de l'estimateur E sont un état de navigation du porteur et éventuellement d'états internes de la centrale inertielle.
L'estimateur E comprend notamment un filtre de Kalman étendu EKF configuré pour fusionner les informations données par les capteurs complémentaires et les capteurs inertiels de façon à fournir une estimation optimale des informations de navigation.
La fusion est faite d'après un système dynamique continu servant de modèle pour prédire l'état à chaque instant à l'aide d'une fonction de propagation f non linéaire, ainsi que la façon de l'observer à l'aide d'une fonction d'observation h pouvant être non linéaire également (voir à ce propos l'Annexe 5 rappelant quelques principes sur les systèmes dynamiques), cette fonction dépendant du type de capteur CC utilisé :

$$\begin{cases} \dot{X}(t) = f\big(X(t), u(t)\big) \\ \quad z(t) = h\big(X(t)\big) \end{cases}$$

u(t) représente la commande d'entrée constituée de la force spécifique et de la vitesse angulaire. Ces 2 grandeurs sont mesurées par les capteurs CI de façon discrète dans le temps selon une période $T_1$.

L'état global $X(t)$ comporte entre autres les coordonnées de position, de vitesse, ainsi que l'orientation du porteur sous forme d'une ou plusieurs rotations, chacune d'elles représentée par exemple par une matrice ou un quaternion d'attitude.

L'estimateur E exploite une version discrète de ces équations à temps continu obtenue selon les règles de l'état de l'art :

$$\begin{cases} X_k = g(X_{k-1}, u_{k-1}) \\ z_k = h(X_k) \end{cases}$$

Le filtre EKF fonctionne de manière itérative selon une étape de prédiction prenant en compte les mesures des capteurs CI et une étape de mise à jour prenant en compte les mesures des capteurs CC :

L'étape de prédiction comprend la prédiction d'un état global estimé, et la prédiction d'une covariance associée.

Prédiction état global estimé : $\hat{X}_{k|k-1} = g(\hat{X}_{k-1|k-1}, u_{k-1})$

Prédiction covariance associée : $\hat{P}_{k|k-1} = \phi_{k-1 \to k} \hat{P}_{k-1|k-1} \phi_{k-1 \to k}^T + Q_{k-1}$ où $\phi_{k-1 \to k}$ correspond à la matrice de transition dépendant de la fonction de propagation f, et Q la matrice de bruits de modèle.

L'étape de mise à jour utilise les variables suivantes :

Innovation : $\tilde{y}_k = z_k - h(\hat{X}_{k|k-1})$

Covariance innovation : $\hat{S}_k = H_k \hat{P}_{k-1|k-1} H_k^T + R_k$ où $H_k$ correspond à la matrice d'observation.

Gain de Kalman : $K_k = \hat{P}_{k-1|k-1} H_k^T S_k^{-1}$

La mise à jour est mis en oeuvre comme suit :

Mise à jour état global estimé : $\hat{X}_{k|k} = \hat{X}_{k|k-1} + K_k \tilde{y}_k$
Mise à jour covariance associée : $\hat{P}_{k|k} = (I - K_k H_k) \hat{P}_{k|k-1}$

Matrice de transition théorique : $\phi_{k-1 \to k} = \int_{(k-1)T}^{kT} exp\big(F(\tau)\big) d\tau$

Avec : $F(t) = \dfrac{\partial f}{\partial X}\Big|_{X(t), u(t)}$

Matrice d'observation : $H_k = \dfrac{\partial h}{\partial X}\Big|_{\hat{X}_{k|k-1}}$

L'estimateur E bien que proche de cet algorithme en est légèrement différent. La mise à jour de l'état global peut ne pas se faire de façon totalement additive, notamment pour préserver les propriétés des matrices de rotation, et notamment également pour tenir compte du rythme rapide des mesures des capteurs CI. La prédiction de l'état global estimé peut se faire alors à un rythme plus rapide que celui des autres opérations. La différence de rythme peut dépendre de la dynamique du porteur. D'autres différences sont possibles. Par exemple, une approximation peut être faite sur la matrice de transition.

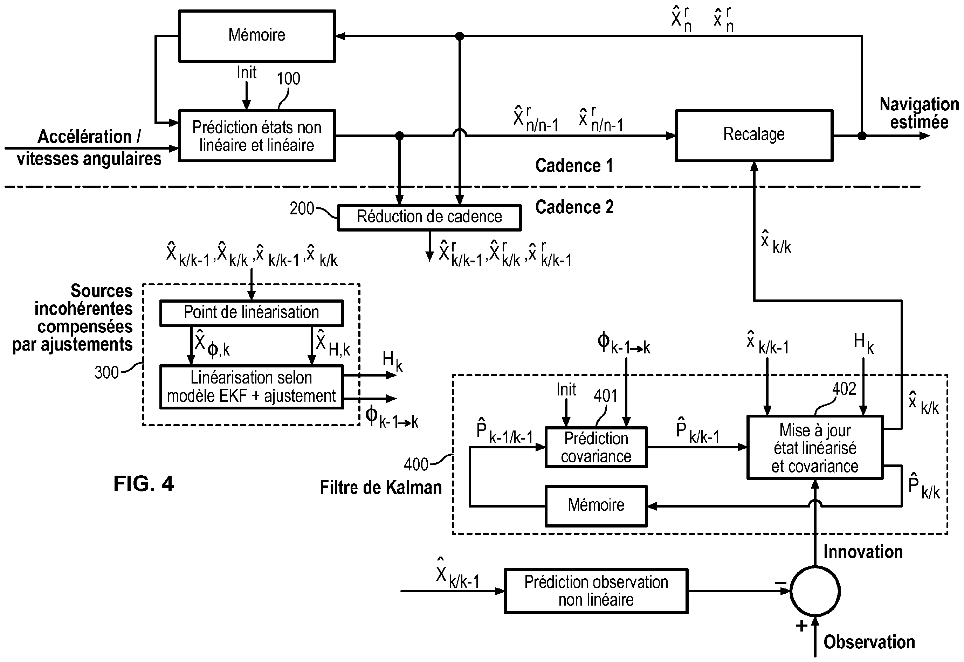

Est illustré sur la **figure 4** un estimateur E selon un mode de réalisation comprenant différents blocs fonctionnels correspondant à des étapes respectives de sa mise en oeuvre.

L'estimation est mis en oeuvre en itérations successives, chaque itération étant identifiée par un indice k.

La prédiction de l'état global estimé selon une cadence 1 est effectuée dans l'étape 100.

Une mémoire sur 1 cycle, ainsi qu'une étape de recalage fonctionnent au même rythme. Cette étape de recalage prend en compte des données mises à jour à une cadence 2, plus lente.

Tous les autres traitements fonctionnent à la cadence 2. L'étape 200 convertit des états de cadence 1 en des états de cadence 2. A la cadence 2, $\hat{X}_{k|k-1}$, $\hat{x}_{k|k-1}$, $\hat{X}_{k|k}$, $\hat{x}_{k|k}$, ce dernier état provenant de la dernière mise à jour du filtre de Kalman 400, représentent dans l'ordre l'état global prédit, l'état linéarisé prédit, l'état global mis à jour, l'état linéarisé mis à jour. L'état $\hat{x}_{k|k-1}$, peut dans certains cas être toujours à 0.

Les matrices de transition et d'observation sont calculées dans l'étape de linéarisation 300. Une sous-étape d'ajustement, propre à l'invention et détaillée plus loin, y est ajoutée.

L'innovation est calculée d'après l'état global prédit et d'après l'observation des capteurs CC représentée en bas de la **figure 4.**

Les autres étapes de l'EKF sont regroupées dans l'étape 400 réalisant des estimations à l'aide de matrices, et constituant un filtre de Kalman, ces estimations portant sur des états linéarisés et des covariances. Une particularité provient du fait que l'étape 400 ne comporte pas de prédiction d'état linéarisé, laquelle peut éventuellement être incorporée dans l'étape 100 à cadence 1.

L'étape 401 comporte la prédiction de la covariance associée à l'état global prédit et exploite la matrice de transition. L'étape 402 comporte le calcul de la covariance de l'innovation, des gains de Kalman, de la mise à jour de la covariance de l'état global, et de la mise à jour de l'état linéarisé. Cette étape exploite la matrice d'observation.

Les points de linéarisation dans l'étape 300 peuvent être calculés en fonction de $\hat{X}_{k/k-1}$, $\hat{x}_{k/k-1}$, $\hat{X}_{k/k}$, $\hat{x}_{k/k}$, ce dernier état provenant de la dernière mise à jour du filtre de Kalman 400. Si $\hat{x}_{k/k-1}$, $= \hat{x}_{k/k} = 0$, alors $\hat{X}_{\phi,k-1} = \hat{X}_{k-1/k-1}$ et $\hat{X}_{H,k} = \hat{X}_{k/k-1}$.

Un premier point de linéarisation $\hat{X}_{\phi,k-1}$ permet de calculer dans l'étape 300 la matrice de transition $\phi_{k-1 \to k}(\hat{X}_{\phi,k-1})$ à la période de Kalman correspondant à la cadence 2. Ce point de linéarisation correspond à l'état global estimé après le dernier recalage.

Un deuxième point de linéarisation $\hat{X}_{H,k}$ permet de calculer au cycle de Kalman k dans l'étape 300 la matrice d'observation $H_k(\hat{X}_{H,k})$. Ce point de linéarisation est obtenu d'après les calculs de l'étape 100. Il correspond au dernier état prédit avant le prochain recalage.

Afin de simplifier les notations, la matrice de transition $\phi_{k-1 \to k}(\hat{X}_{\phi,k-1})$ sera notée désormais $\phi_{k-1 \to k}$, et la matrice d'observation $H_k(\hat{X}_{H,k})$ notée désormais $H_k$. $\phi_{k-1 \to k}$ et $H_k$ s'expriment donc chacune en fonction d'un état global correspondant à leurs points de linéarisation respectifs $\hat{X}_{\phi,k-1}$ et $\hat{X}_{H,k}$.

Comme dit précédemment, les étapes sont répétées récursivement à l'itération suivante d'instant k+1 à la cadence 2, cadence du filtre de Kalman.

*Ajustement des matrices de transition et d'observation*

L'étape de linéarisation mise en oeuvre dans chaque cycle de Kalman constitue un point faible de l'estimateur E.

Aussi, le procédé d'estimation comprend dans l'étape 300, une étape supplémentaire d'ajustement en fonction d'une condition d'observabilité, venant ajuster, avant leur utilisation par le filtre de Kalman, les matrices générées par cette étape de linéarisation : D'une part la matrice de transition servant à propager la matrice de covariance, et d'autre part la matrice d'observation.

La condition d'observabilité consiste en une contrainte imposée au noyau de la matrice d'observabilité (la définition de cette matrice est indiquée en annexe 6) au travers d'un ajustement des matrices de transition et d'observation de façon à inclure dans le noyau un modèle prédéterminé de sous-espace vectoriel non observable. Ce modèle de non-observabilité consiste en une équation dans l'espace d'état d'un sous-espace vectoriel représenté par une base, en fonction d'un état global, ce sous-espace vectoriel étant mis à jour à chaque cycle de Kalman. Le fait d'inclure ce sous-espace dans le noyau de la matrice d'observabilité le rend non observable et diminue le risque d'incohérence si le modèle est pertinent.

L'état global à partir duquel est calculé le sous-espace vectoriel rendu non observable correspond au point de linéarisation de la fonction d'observation (Voir annexe 6). Un vecteur non observable a en effet une image nulle au travers de la matrice d'observation, et ce vecteur correspond à un état linéarisé au voisinage d'un état global correspondant au point de linéarisation de la fonction d'observation.

Au cours de l'étape d'ajustement, on va calculer, pour chacune des deux matrices de transition et d'observation, un écart matriciel correspondant.

Par convention, on utilisera dans la suite des notations étoilées pour désigner les matrices de transition et d'observation obtenues par l'ajustement.

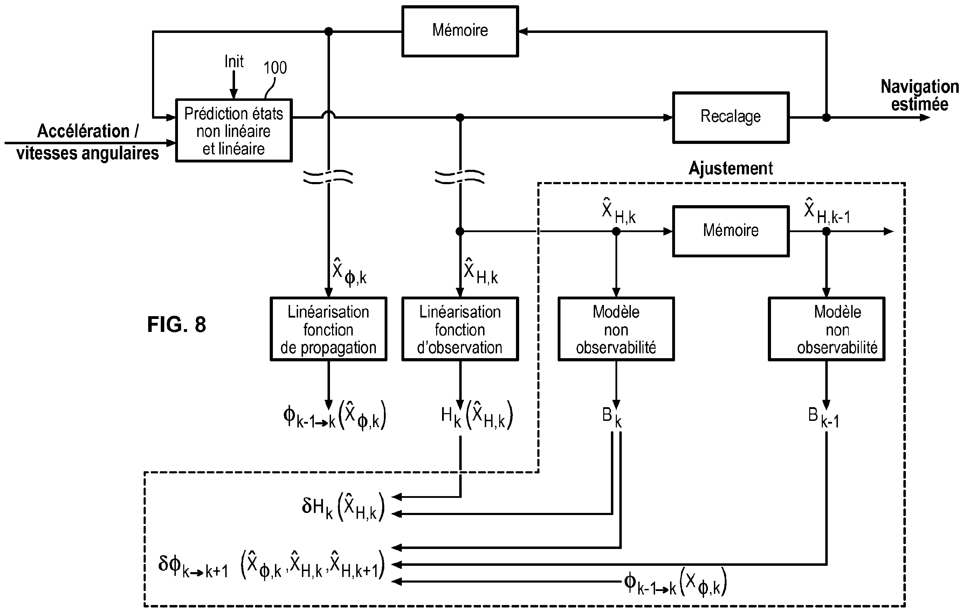

Le flux des données nécessaires au calcul d'ajustement est représenté de façon schématique sur la figure 8, mettant en évidence le fait que l'ajustement de la matrice d'observation dépend du point de linéarisation de la fonction d'observation dans le cycle de Kalman courant, et que l'ajustement de la matrice de transition dépend du point de linéarisation de la fonction d'observation dans le cycle courant et dans le cycle précédent.

Il est donc nécessaire d'exploiter une base $B_k$ générant le sous-espace vectoriel non observable au cycle k, ainsi qu'une base $B_{k-1}$ générant le sous-espace vectoriel non observable au cycle k-1.

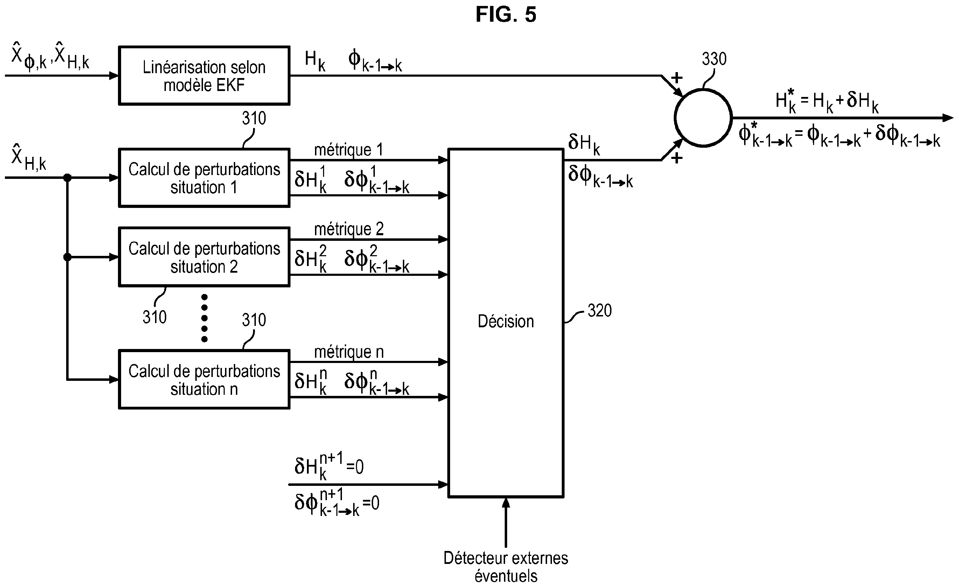

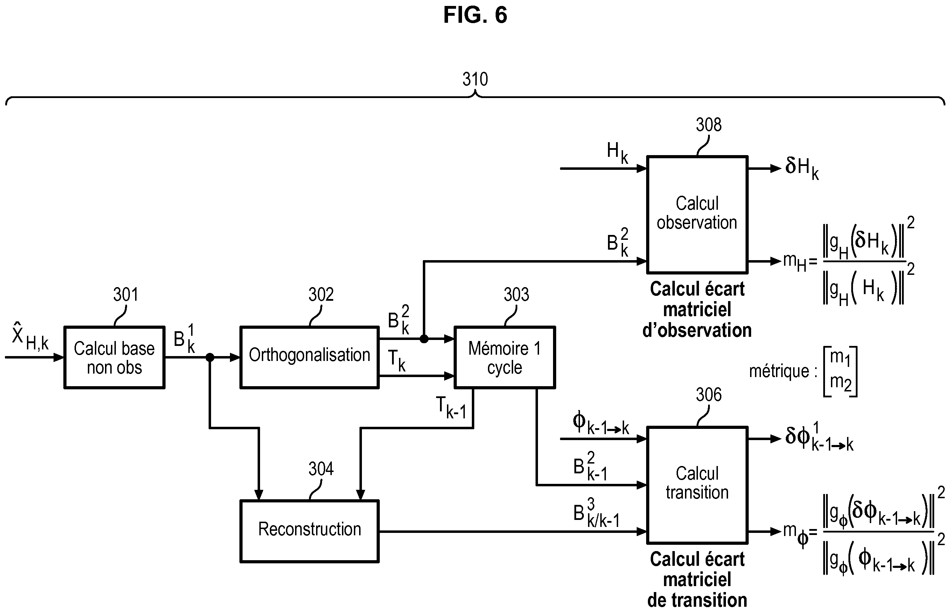

Il est possible alors, sur un cycle de Kalman, de mémoriser le point de linéarisation et de générer 2 fois par cycle la base non observable, ainsi que cela est représenté sur la figure X. Il est possible de façon équivalente sur un cycle de Kalman, de mémoriser la base non observable de façon à ne la générer qu'une fois par cycle. Cette deuxième option correspond au schéma de principe de la **figure 6.** Celle-ci détaille les fonctions d'ajustement décrites sur la **figure 5.**

La **figure 6** détaille les calculs conduisant à l'obtention des deux écarts matriciels relatifs aux matrices de transition et d'observation au cycle de Kalman d'instant k.

La matrice de transition du cycle de Kalman k-1 au cycle k et la matrice d'observation au cycle k sont ajustées d'après un modèle de non observabilité utilisant les vecteurs d'état globaux $\hat{X}_{H,k-1}$ et $\hat{X}_{H,k}$, points de linéarisation de la fonction d'observation aux cycles k-1 et k. Ce modèle permet d'estimer, dans une étape 301, l'espace non observable des états linéarisés sous forme d'une base primaire non observable $B_k^1$. Une telle base peut être calculée à chaque cycle de Kalman en utilisant une fonction analytique obtenue lors de la conception du filtre d'après la méthode présentée en Annexe 6 à l'aide d'un système dynamique à temps continu, puis appliquée au système dynamique à temps discret utilisé par la centrale de navigation.

Deux exemples de situations à risques pouvant être traitées selon le procédé de l'invention sont décrits en annexe 1. Un modèle de base non observable propre à l'alignement statique est développé en Annexe 2.

Des hypothèses simplificatrices sont nécessairement faites pour élaborer ce modèle lors de la phase de conception car aucune équation contenant un nombre limité de variables ne peut représenter le monde vrai. Il est possible ainsi que le nuage d'erreur vrai se réduise lentement selon toutes les directions de l'espace d'état mais que l'EKF, en raison des non-linéarités et des bruits d'estimation, estime une décroissance plus rapide selon certains axes, ce qui crée une incohérence. Il est possible alors de modéliser la décroissance lente selon un certain axe par une décroissance nulle dans le temps et de considérer cet axe non observable afin de pouvoir y imposer une contrainte. Cette simplification réduit légèrement la précision mais garantit la cohérence des estimations. Mais comme il n'est plus nécessaire de recourir à des bruits de modèle pour empêcher l'enveloppe 3 sigma estimée de se réduire le long des axes non observables, il en découle finalement un gain en précision.

L'alignement statique décrit en annexe 1 est un exemple de situation dans laquelle le modèle ne prend pas en compte les petits mouvements imperceptibles qui, à court terme n'ont pas d'effet, mais qui peuvent être observés sur le long terme, ce qui provoque une décroissance lente de l'enveloppe 3 sigma vraie sur certains axes. Il est proposé, par soucis de simplification du modèle, de ne pas en tenir compte et de modéliser une base non observable en considérant que ces petits mouvements sont nuls, ce qui est un exemple de simplification. Dans le deuxième exemple de l'annexe 1, le mouvement de houle peut au même titre être négligé pour modéliser la base non observable.

Si la base $B_k^1$ est orthogonale, il existe une solution décrite dans l'annexe 3 permettant d'ajuster les matrices de façon simple. Cependant, cette condition, dans le cas général, n'est pas satisfaite. La solution proposée consiste à orthogonaliser la base puis à effectuer l'ajustement. Les traitements décrits ci-dessous sont justifiés par le paragraphe en fin de l'annexe 3 traitant de la base non orthogonale.

Dans une étape d'orthogonalisation 302, la base primaire $B_k^1$ est orthogonalisée en une base secondaire $B_k^2$ selon une variante de la méthode de Gramm-Schmitt, la particularité provenant du fait que les vecteurs ne sont pas rendus unitaires car la normalisation est incluse implicitement dans la formule d'ajustement des matrices présentée

$$T_k = \left[a_{i,j,k}\right]_{\substack{1 \le i \le q \\ 1 \le j \le q}}$$

par la suite. Cette opération génère une matrice de coefficients ayant servi à l'orthogonalisation.

Soit q le nombre de vecteurs de la base primaire non observable. On pose :

$$B_k^1 = \left[\hat{v}_{1,1,k} \quad \hat{v}_{1,2,k} \quad ... \quad \hat{v}_{1,q,k}\right],$$

et

$$B_k^2 = \left[\hat{v}_{2,1,k} \quad \hat{v}_{2,2,k} \quad ... \quad \hat{v}_{2,q,k}\right]$$

Au cycle k, l'étape d'orthogonalisation peut mettre en oeuvre le calcul suivant :

$$\hat{v}_{2,1,k} = \hat{v}_{1,1,k} \quad , \quad T_k = \left[0\right]_{\substack{1 \le i \le q \\ 1 \le j \le q}}$$

$$\hat{v}_{2,i,k} = \hat{v}_{1,i,k} - \sum_{j=1}^{i-1} a_{i,j,k}\hat{v}_{2,j,k}$$

Puis : $\forall i \ge 2, i \le q$ :

$$a_{i,j,k} = \begin{cases} \dfrac{\left(\hat{v}_{2,j,k}^{T}\hat{v}_{1,i,k}\right)}{\left(\hat{v}_{2,j,k}^{T}\hat{v}_{2,j,k}\right)} & \text{si } 2 \leq i \leq q \\ & \text{et } 1 \leq j < i \\ 0 & \text{sinon} \end{cases}$$

Avec : coefficients rassemblés dans $T_k$

Cette base $B_k^2$ ainsi que les coefficients d'orthogonalisation $T_k$ sont mémorisés à l'étape 303 pendant un cycle de Kalman.

La base $B_k^2$ permet de calculer dans une étape 308 un écart matriciel $\delta H_k$ relatif à la matrice d'observation $H_k$, et ce sans inversion d'une quelconque matrice, ce qui peut permettre de réduire la charge de calcul. Cette étape peut être omise si la matrice d'observation est indépendante de l'état estimé. Dans ce cas, l'écart matriciel est nul.

Il est possible de décomposer l'écart matriciel $\delta H_k$ relatif à la matrice d'observation $H_k$, en q écarts matriciels élémentaires :

$$\delta H_k = \sum_{i=1}^{q} \delta H_{i,k}$$

Cette décomposition permet ainsi de paralléliser le calcul de chaque écart matriciel élémentaire et ainsi de raccourcir le temps de calcul de l'étape 308.

Chaque écart matriciel élémentaire peut, d'après l'annexe 3, être calculé comme suit : Pour i compris entre 1 et q,

$$\delta H_{i,k} = -\frac{1}{\hat{v}_{2,i,k}^{T}\hat{v}_{2,i,k}}\left(H_k\hat{v}_{2,i,k}\right)\hat{v}_{2,i,k}^{T}$$

Par ailleurs, au cycle k, la base $B_k^1$ et les coefficients $T_{k-1}$ (mémorisés au cycle de Kalman précédent k-1) permettent de reconstruire une base non observable $B_{k/k-1}^3$ dans une étape de reconstruction référencée 304. Cette base reconstruite à l'instant k dépend de la base primaire à l'instant k, mais aussi des coefficients d'orthogonalisation à l'instant k-1. Son indice est donc noté k/k-1 correspondant à l'instant k sachant les estimations à l'instant k-1. Les bases $B_{k-1}^2$ et $B_{k/k-1}^3$ permettent de calculer l'écart matriciel $\delta\phi_{k\text{-}1\rightarrow k}$ sans inversion de matrice.

On pose :

$$B_{k/k-1}^3 = \begin{bmatrix} \hat{v}_{3,1,k/k-1} & \hat{v}_{3,2,k/k-1} & \cdots & \hat{v}_{3,q,k/k-1} \end{bmatrix}$$

Au cycle k, l'étape de reconstruction 304 peut mettre en oeuvre le calcul suivant :

$$\overline{T_{k-1} = \begin{bmatrix} a_{i,j,k-1} \end{bmatrix}}_{\substack{1 \leq i \leq q \\ 1 \leq j \leq q}}$$

Coefficients $\alpha_{j,k\text{-}1}$ extraits de

$$\hat{v}_{3,1,k/k-1} = \hat{v}_{1,1,k}$$

$$\hat{v}_{3,i,k/k-1} = \hat{v}_{1,i,k} - \sum_{j=1}^{i-1} a_{i,j,k-1}\hat{v}_{3,j,k/k-1}$$

Puis: $\forall i \geq 2$, $i \leq q$ :

Dans une étape référencée 306, on calcule un écart matriciel relatif à la matrice de transition.

Il est possible de décomposer l'écart matriciel $\delta\phi_{i,k\text{-}1\rightarrow k}$ relatif à la matrice de transition $\phi_{i,k\text{-}1\rightarrow k}$, en q écarts matriciels élémentaires :

$$\delta\phi_{k-1\rightarrow k} = \sum_{i=1}^{q} \delta\phi_{i,k-1\rightarrow k}$$

Chaque écart matriciel élémentaire peut, d'après l'annexe 3, être calculé comme suit :
Pour i compris entre 1 et q,

$$\delta\phi_{i,k-1\rightarrow k} = \frac{1}{\hat{v}_{2,i,k-1}^{T}\hat{v}_{2,i,k-1}}\left(\hat{v}_{3,i,k/k-1} - \phi_{k-1\rightarrow k}\hat{v}_{2,i,k-1}\right)\hat{v}_{2,i,k-1}^{T}$$

Cette décomposition permet ainsi de paralléliser le calcul de chaque écart matriciel élémentaire et ainsi peut permettre de raccourcir le temps de calcul de l'étape 306.

Pour réduire l'occupation mémoire et les calculs, on peut ne considérer qu'une sous-matrice de la matrice de transition : Celle en correspondance avec les valeurs non nulles des vecteurs non observables.

Les deux écarts matriciels obtenus permettent de vérifier une condition importante d'observabilité, condition qui est détaillée en Annexe 7.

Par ailleurs, l'Annexe 3 explique l'origine de la méthode de calcul, et l'annexe 8 en donne une démonstration mathématique.

L'étape de calcul 306 produit en outre une métrique représentative d'une amplitude d'ajustement induite par l'écart matriciel relatif à la matrice de transition.

L'étape de calcul 308 produit en outre une métrique représentative d'une amplitude d'ajustement induite par l'écart matriciel relative à la matrice d'observation.

Le même type de calcul de métrique peut être mis en oeuvre pour la matrice de transition et la matrice d'observation. Par exemple, pour la matrice de transition, on calcule séparément le carré de la norme de l'écart matriciel, et celui de la matrice de transition. La métrique correspond alors au rapport de ces deux grandeurs, ou à la racine carrée du rapport de ces deux grandeurs.

La norme utilise éventuellement des coefficients de pondération pour normaliser les grandeurs intervenant dans le vecteur d'état. Par exemple, une erreur de position peut être de l'ordre de quelques mètres, alors qu'une erreur d'attitude peut-être de l'ordre de quelques milli-radians. La norme de matrice peut correspondre à la norme du vecteur que l'on formerait en mettant tous les termes de la matrice sous la forme d'un vecteur colonne (norme de Froebenius).

L'Annexe 4 explique comment exploiter des coefficients de pondération dans le calcul de métriques.

Le calcul de métriques fait appel éventuellement à des fonctions de pondération $g_{\phi}()$ et $g_{H}()$. Si la matrice d'observation $H_k$ est indépendante de l'état estimé, l'écart matriciel $\delta H_k$ *est* nul, et sa métrique est nulle. Il est inutile de la calculer. Identiquement, si la matrice de transition est indépendante de l'état estimé, le calcul de la métrique associée peut être omise.

De retour à la **figure 5,** dans une étape de décalage 330, la matrice de transition est sommée à l'écart matriciel associé, de façon à obtenir une matrice de transition ajustée ; et la matrice d'observation est sommée à l'écart matriciel associé, de façon à obtenir une matrice d'observation ajustée.

La séquence 310 illustrée en **figure 6** produisant une paire d'écarts matriciels et une paire de métriques peut être mise en oeuvre n fois en parallèle.

On suppose que l'on connaît, pour n situations prédéterminées dans le domaine continu, un modèle de base non observable. Ce modèle provient de la résolution d'un système d'équations représentatives d'un type d'observation respectif et éventuellement d'une trajectoire respective du vecteur d'état, dont une méthode est donnée en Annexe 6.

Dans une étape de décision 320, l'une des n paires d'écart matriciels est élue (par exemple la paire obtenue par l'ajustement correspondant à la situation i), et l'étape de décalage est mise en oeuvre seulement avec cette paire de matrices pour produire les matrices ajustées.

L'étape de décision 320 réalise un test de vraisemblance sur chaque paire d'écarts matriciels, en inspectant la valeur des métriques correspondantes. Ce test permet de prendre la décision de reconnaître telle ou telle situation.

L'écart matriciel élu est l'écart matriciel candidat associée à la métrique représentative de l'amplitude d'ajustement la plus faible. Ainsi, l'ajustement est réalisé avec les écarts matriciels les plus « vraisemblables ». Le critère de vraisemblance peut porter sur l'ajustement de la matrice de transition et/ou de la matrice d'observation.

Par ailleurs, le décalage n'est mis en oeuvre que si la métrique de l'écart matriciel élu est inférieure à un seuil prédéterminé : il peut en effet être préférable de ne pas opérer de décalage des matrices de transition et d'observation, si ce décalage n'est pas considéré suffisamment fiable et introduit un bruit supplémentaire dans le système plutôt qu'il n'en corrige.

Le procédé d'estimation qui précède peut être mis en oeuvre par un programme d'ordinateur exécuté par les moyens de calcul de la centrale inertielle IN. Par ailleurs, la carte 1 d'identification comporte un produit programme d'ordinateur comprenant des instructions de code de programme pour l'exécution des étapes du procédé décrit, lorsque ce programme est exécuté par la carte 1 d'identification.

*ANNEXE 1 : Exemples de situations à risque d'une centrale inertielle de navigation exploitant un filtre EKF*

Un premier exemple concerne une centrale inertielle de navigation en phase d'alignement statique au sol. Dans cette phase, la verticale locale est estimée en mesurant le vecteur de pesanteur à l'aide des accéléromètres, et l'orientation de la centrale est estimée en mesurant le vecteur de vitesse angulaire de rotation terrestre à l'aide des gyromètres. L'observation utilisée dans cette phase est typiquement la ZUPT (Zéro velocity Update) qui est une observation d'un capteur virtuel indiquant que la vitesse du porteur est nulle par rapport à la Terre. L'erreur de mesure est modélisée par un bruit blanc. Or, il arrive que les capteurs inertiels enregistrent des petits mouvements non aléatoires dus par exemple au vent ou à des effets de dilatation dus à la chaleur. Cela correspond à une erreur de mesure déterministe non prise en compte dans le modèle de capteur non inertiel produisant l'observation ZUPT. Il y a alors incohérence entre le système dynamique vrai et le système dynamique modélisé. Tant que la durée de l'alignement statique est courte, l'incohérence est négligeable. Il existe par contre de nombreuses applications nécessitant un alignement de plusieurs heures, ou de plusieurs jours, semaines ou mois. Dans ce cas, il est possible que l'incohérence devienne prépondérante.

Un deuxième exemple concerne une centrale inertielle de navigation montée sur un bateau de surface exploitant une observation de vitesse en projection dans le repère bateau. Cette mesure non inertielle est faite en général à l'aide d'un capteur « Loch » et il s'agit de plus d'une mesure relative par rapport à l'eau. Le fait qu'elle soit réalisée en projection dans le repère bateau crée une dépendance de la mesure vis-à-vis de l'attitude du bateau. Il est possible alors, en supposant que seule cette observation soit utilisée, qu'une incohérence apparaisse entre les estimations du filtre EKF et le monde vrai, et que cette incohérence produise des erreurs importantes au bout de plusieurs heures si le bateau navigue à cap constant.

*ANNEXE 2 : Modèle d'axes non observables en alignement statique*

Cette annexe présente la modélisation de la base non observable permettant de résoudre l'incohérence du premier exemple de l'annexe 1 à l'aide du procédé proposé.

Hypothèses : Le filtre de Kalman exploite le modèle d'erreurs en PHI et la mécanisation fonctionne en azimuth libre.

Les notations suivantes sont utilisées :

| | |
|---|---|
| [t] | Repère terrestre. x=axe de rotation |
| [m] | Repère de mesure |
| [v] | Repère plateforme, en azimuth libre |
| $T_{vt}$ | Matrice de passage de [t] à [v] |
| $T_{vm}$ | Matrice de passage de [m] à [v] |
| $\alpha$ | Angle de mécanisation |
| $\Omega_t$ | Vitesse de rotation terrestre |
| $g$ | Module de la gravité (gravité = pesanteur ≠ gravitation) |
| $g_e$ | Module de la gravité à l'équateur |
| $a_0, K_1, K_2$ | Constantes liées aux constantes géodésiques WGS84 |
| $R_x$ | Rayon de courbure de l'ellipsoïde de référence dans la direction x de [v] |
| $R_y$ | Rayon de courbure de l'ellipsoïde de référence dans la direction y de [v] |
| $R_N$ | Rayon de courbure de l'ellipsoïde de référence dans la direction Nord |
| $R_E$ | Rayon de courbure de l'ellipsoïde de référence dans la direction Est |
| $\tau$ | Torsion géodésique sur l'ellipsoïde de référence |
| $L$ | Latitude |
| $z$ | Altitude |

(suite)

| | |
|---|---|
| $\Delta x$ | Erreur de position selon l'axe x de [v] |
| $\Delta y$ | Erreur de position selon l'axe y de [v] |
| $\Delta z$ | Erreur de position selon l'axe z de [v] |
| $\Delta V_x$ | Erreur de vitesse selon l'axe x de [v] |
| $\Delta V_y$ | Erreur de vitesse selon l'axe y de [v] |
| $\Delta V_z$ | Erreur de vitesse selon l'axe z de [v] |
| $\phi_x$ | Erreur de rotation selon l'axe x de [v] |
| $\phi_y$ | Erreur de rotation selon l'axe y de [v] |
| $\phi_z$ | Erreur de rotation selon l'axe z de [v] |
| $\Delta b_{xm}$ | Erreur de biais accéléro selon l'axe x de [m] |
| $\Delta b_{ym}$ | Erreur de biais accéléro selon l'axe y de [m] |
| $\Delta b_{zm}$ | Erreur de biais accéléro selon l'axe z de [m] |
| $\Delta K_{xm}$ | Erreur de facteur d'échelle accéléro selon l'axe x de [m] |
| $\Delta K_{ym}$ | Erreur de facteur d'échelle accéléro selon l'axe y de [m] |
| $\Delta K_{zm}$ | Erreur de facteur d'échelle accéléro selon l'axe z de [m] |
| $\Delta d_{xm}$ | Erreur de dérive gyro selon l'axe x de [m] |
| $\Delta d_{ym}$ | Erreur de dérive gyro selon l'axe y de [m] |
| $\Delta d_{zm}$ | Erreur de dérive gyro selon l'axe z de [m] |

Les composantes d'états intervenant dans les équations sont présentées dans un ordre arbitraire qui est le suivant :

| | | |
|---|---|---|
| | $\begin{bmatrix} \Delta x \\ \Delta y \\ \Delta z \end{bmatrix}$ | Erreurs de position adns le repère plateforme [v] |
| | $\begin{bmatrix} \phi_x \\ \phi_y \\ \phi_z \end{bmatrix}$ | Erreurs d'attitude dans le repère plateforme [v] |
| | $\begin{bmatrix} \Delta b_{xm} \\ \Delta b_{ym} \\ \Delta b_{zm} \end{bmatrix}$ | Erreurs de biais accéléro dans le repère de mesure [m] |

(suite)

| $N = \begin{bmatrix} \begin{bmatrix} \Delta x \\ \Delta y \\ \Delta z \end{bmatrix} \\ \begin{bmatrix} \phi_x \\ \phi_y \\ \phi_z \end{bmatrix} \\ \begin{bmatrix} \Delta b_{xm} \\ \Delta b_{ym} \\ \Delta b_{zm} \end{bmatrix} \\ \begin{bmatrix} \Delta K_{xm} \\ \Delta K_{ym} \\ \Delta K_{zm} \end{bmatrix} \\ \begin{bmatrix} \Delta d_{xm} \\ \Delta d_{ym} \\ \Delta d_{zm} \end{bmatrix} \\ \Delta \alpha \end{bmatrix}$ Autres composantes : nulles | $\begin{bmatrix} \Delta K_{xm} \\ \Delta K_{ym} \\ \Delta K_{zm} \end{bmatrix}$ | Erreurs de facteur d'échelle accéléro dans le repère de mesure [m] |
|---|---|---|
| | $\begin{bmatrix} \Delta d_{xm} \\ \Delta d_{ym} \\ \Delta d_{zm} \end{bmatrix}$ | Erreurs de dérive gyro dans le repère de mesure [m] |
| | $\Delta \alpha$ | Erreur d'angle de mécanisation en azimuth libre |

Les mesures acquises sont des vitesses. Le porteur est supposé parfaitement immobile en translation et rotation. Les défauts capteurs sont supposés constants dans le temps.

| Accéléromètres | | gyromètres |
|---|---|---|
| $\dfrac{d}{dt}\begin{bmatrix} \Delta b_{xm} \\ \Delta b_{ym} \\ \Delta b_{zm} \end{bmatrix} = \begin{bmatrix} 0 \\ 0 \\ 0 \end{bmatrix}$ | $\dfrac{d}{dt}\begin{bmatrix} \Delta K_{xm} \\ \Delta K_{ym} \\ \Delta K_{zm} \end{bmatrix} = \begin{bmatrix} 0 \\ 0 \\ 0 \end{bmatrix}$ | $\dfrac{d}{dt}\begin{bmatrix} \Delta d_{xm} \\ \Delta d_{ym} \\ \Delta d_{zm} \end{bmatrix} = \begin{bmatrix} 0 \\ 0 \\ 0 \end{bmatrix}$ |

Ces équations forment un système stationnaire de la forme :

$$\frac{d}{dt}\begin{bmatrix} \Delta x \\ \Delta y \\ \Delta z \end{bmatrix} = \begin{bmatrix} \Delta V_x \\ \Delta V_y \\ \Delta V_z \end{bmatrix}$$

$$\frac{d}{dt}\begin{bmatrix} \Delta V_x \\ \Delta V_y \\ \Delta V_z \end{bmatrix} = T_{vm}\begin{bmatrix} -\Delta b_{xm} \\ -\Delta b_{ym} \\ -\Delta b_{zm} \end{bmatrix} + T_{vm}\begin{bmatrix} -\Delta K_{xm} & 0 & 0 \\ 0 & -\Delta K_{ym} & 0 \\ 0 & 0 & -\Delta K_{zm} \end{bmatrix} T_{mv}\begin{bmatrix} 0 \\ 0 \\ g \end{bmatrix} - \begin{bmatrix} 0 & -g & 0 \\ g & 0 & 0 \\ 0 & 0 & 0 \end{bmatrix}\begin{bmatrix} \phi_x \\ \phi_y \\ \phi_z \end{bmatrix}$$

$$+ \begin{bmatrix} 0 & -m_{21} & -m_{31} \\ m_{21} & 0 & -m_{32} \\ m_{31} & m_{32} & 0 \end{bmatrix}\begin{bmatrix} \Delta V_x \\ \Delta V_y \\ \Delta V_z \end{bmatrix} + \begin{bmatrix} 0 & 0 & 0 \\ 0 & 0 & 0 \\ p_{31} & p_{32} & p_{33} \end{bmatrix}\begin{bmatrix} \Delta x \\ \Delta y \\ \Delta z \end{bmatrix} + \begin{bmatrix} q_1 \\ q_2 \\ q_3 \end{bmatrix}\Delta\alpha$$

$$\frac{d}{dt}\begin{bmatrix} \phi_x \\ \phi_y \\ \phi_z \end{bmatrix} = T_{vm}\begin{bmatrix} \Delta d_{xm} \\ \Delta d_{ym} \\ \Delta d_{zm} \end{bmatrix} + A\left(\begin{bmatrix} c_1 \\ c_2 \\ c_3 \end{bmatrix}\right)\begin{bmatrix} \phi_x \\ \phi_y \\ \phi_z \end{bmatrix} + \begin{bmatrix} \frac{1}{\tau} \\ -\frac{1}{R_x} \\ 0 \end{bmatrix}\Delta V_x + \begin{bmatrix} \frac{1}{R_y} \\ -\frac{1}{\tau} \\ 0 \end{bmatrix}\Delta V_y + \Omega_t\begin{bmatrix} a_1 \\ a_2 \\ a_3 \end{bmatrix}\Delta x + \Omega_t\begin{bmatrix} b_1 \\ b_2 \\ b_3 \end{bmatrix}\Delta y$$

$$+ \Omega_t\begin{bmatrix} -T_{vt}^{21} \\ T_{vt}^{11} \\ 0 \end{bmatrix}\Delta\alpha$$

La méthode de recherche des vecteurs non observables :

On recherche $\begin{bmatrix} \Delta V_x \\ \Delta V_y \\ \Delta V_z \end{bmatrix}, \begin{bmatrix} \Delta b_{xm} \\ \Delta b_{ym} \\ \Delta b_{zm} \end{bmatrix}, \begin{bmatrix} \Delta K_{xm} \\ \Delta K_{ym} \\ \Delta K_{zm} \end{bmatrix}, \begin{bmatrix} \Delta d_{xm} \\ \Delta d_{ym} \\ \Delta d_{zm} \end{bmatrix}$ tels que :

$$\forall n \geq 0, \quad \frac{d^n}{dt^n}\begin{bmatrix} \Delta V_x \\ \Delta V_y \\ \Delta V_z \end{bmatrix} = \begin{bmatrix} 0 \\ 0 \\ 0 \end{bmatrix}$$

Les axes non observables sont les suivants :

| | Axe 1 : $v_1$ | Axe 2 : $v_2$ | Axe 3 : $v_3$ | Axe 4 : $v_4$ |
|---|---|---|---|---|
| $\begin{bmatrix} \Delta x \\ \Delta y \\ \Delta z \\ \Delta V_x \\ \Delta V_y \\ \Delta V_z \\ \phi_x \\ \phi_y \\ \phi_z \\ \Delta b_{xm} \\ \Delta b_{ym} \\ \Delta b_{zm} \\ \Delta K_{xm} \\ \Delta K_{ym} \\ \Delta K_{zm} \\ \Delta d_{xm} \\ \Delta d_{ym} \\ \Delta d_{zm} \\ \Delta\alpha \end{bmatrix}$ | $\begin{bmatrix} 0 \\ 0 \\ 0 \\ 0 \\ 0 \\ 0 \\ 1 \\ 0 \\ 0 \\ T_{mv}\begin{bmatrix} 0 \\ -g \\ 0 \end{bmatrix} \\ 0 \\ 0 \\ 0 \\ T_{mv}\begin{bmatrix} 0 \\ -c_3 \\ c_2 \end{bmatrix} \\ 0 \end{bmatrix}$ | $\begin{bmatrix} 0 \\ 0 \\ 0 \\ 0 \\ 0 \\ 0 \\ 0 \\ 1 \\ 0 \\ T_{mv}\begin{bmatrix} g \\ 0 \\ 0 \end{bmatrix} \\ 0 \\ 0 \\ 0 \\ T_{mv}\begin{bmatrix} c_3 \\ 0 \\ -c_1 \end{bmatrix} \\ 0 \end{bmatrix}$ | $\begin{bmatrix} 0 \\ 0 \\ 0 \\ 0 \\ 0 \\ 0 \\ 0 \\ 0 \\ 1 \\ 0 \\ 0 \\ 0 \\ 0 \\ 0 \\ 0 \\ T_{mv}\begin{bmatrix} -c_2 \\ c_1 \\ 0 \end{bmatrix} \\ 0 \end{bmatrix}$ | $\begin{bmatrix} 0 \\ 0 \\ 0 \\ 0 \\ 0 \\ 0 \\ 0 \\ 0 \\ 0 \\ \begin{bmatrix} 0 \\ 0 \\ -gT_{mv}^{33} \end{bmatrix} \\ 0 \\ 0 \\ 1 \\ 0 \\ 0 \\ 0 \\ 0 \end{bmatrix}$ |

| | Axe 5 : $v_5$ | Axe 6 : $v_6$ | Axe 7 : $v_7$ |
|---|---|---|---|
| $\begin{bmatrix} \begin{bmatrix} \Delta x \\ \Delta y \\ \Delta z \end{bmatrix} \\ \begin{bmatrix} \Delta V_x \\ \Delta V_y \\ \Delta V_z \end{bmatrix} \\ \begin{bmatrix} \phi_x \\ \phi_y \\ \phi_z \end{bmatrix} \\ \begin{bmatrix} \Delta b_{xm} \\ \Delta b_{ym} \\ \Delta b_{zm} \end{bmatrix} \\ \begin{bmatrix} \Delta K_{xm} \\ \Delta K_{ym} \\ \Delta K_{zm} \end{bmatrix} \\ \begin{bmatrix} \Delta d_{xm} \\ \Delta d_{ym} \\ \Delta d_{zm} \end{bmatrix} \\ \Delta\alpha \end{bmatrix}$ | $\begin{bmatrix} 1 \\ 0 \\ 0 \\ 0 \\ 0 \\ 0 \\ 0 \\ 0 \\ 0 \\ T_{mv}\begin{bmatrix} 0 \\ 0 \\ p_{31} \end{bmatrix} \\ 0 \\ 0 \\ 0 \\ T_{mv}\begin{bmatrix} -\Omega_t a_1 \\ -\Omega_t a_2 \\ -\Omega_t a_3 \end{bmatrix} \\ 0 \end{bmatrix}$ | $\begin{bmatrix} 0 \\ 1 \\ 0 \\ 0 \\ 0 \\ 0 \\ 0 \\ 0 \\ 0 \\ T_{mv}\begin{bmatrix} 0 \\ 0 \\ p_{32} \end{bmatrix} \\ 0 \\ 0 \\ 0 \\ T_{mv}\begin{bmatrix} -\Omega_t b_1 \\ -\Omega_t b_2 \\ -\Omega_t b_3 \end{bmatrix} \\ 0 \end{bmatrix}$ | $\begin{bmatrix} 0 \\ 0 \\ 1 \\ 0 \\ 0 \\ 0 \\ 0 \\ 0 \\ 0 \\ T_{mv}\begin{bmatrix} 0 \\ 0 \\ p_{33} \end{bmatrix} \\ 0 \\ 0 \\ 0 \\ 0 \\ 0 \\ 0 \\ 0 \end{bmatrix}$ |

| | Axe 8 : $v_8$ | Axe 9 : $v_9$ | Axe 10 : $v_{10}$ |
|---|---|---|---|
| $\begin{bmatrix} \Delta x \\ \Delta y \\ \Delta z \\ \Delta V_x \\ \Delta V_y \\ \Delta V_z \\ \phi_x \\ \phi_y \\ \phi_z \\ \Delta b_{xm} \\ \Delta b_{ym} \\ \Delta b_{zm} \\ \Delta K_{xm} \\ \Delta K_{ym} \\ \Delta K_{zm} \\ \Delta d_{xm} \\ \Delta d_{ym} \\ \Delta d_{zm} \\ \Delta \alpha \end{bmatrix}$ | $\begin{bmatrix} 0 \\ 0 \\ 0 \\ 0 \\ 0 \\ 0 \\ 0 \\ 0 \\ 0 \\ -gT_{mv}^{13} \\ 0 \\ 0 \\ 1 \\ 0 \\ 0 \\ 0 \\ 0 \\ 0 \\ 0 \end{bmatrix}$ | $\begin{bmatrix} 0 \\ 0 \\ 0 \\ 0 \\ 0 \\ 0 \\ 0 \\ 0 \\ 0 \\ 0 \\ -gT_{mv}^{23} \\ 0 \\ 0 \\ 1 \\ 0 \\ 0 \\ 0 \\ 0 \\ 0 \end{bmatrix}$ | $\begin{bmatrix} 0 \\ 0 \\ 0 \\ 0 \\ 0 \\ 0 \\ 0 \\ 0 \\ 0 \\ 0 \\ 0 \\ 0 \\ 0 \\ 0 \\ 0 \\ T_{mv}\begin{bmatrix}\Omega_t T_{vt}^{21} \\ -\Omega_t T_{vt}^{11} \\ 0 \end{bmatrix} \\ \\ 1 \end{bmatrix}$ |

*ANNEXE 3 : mise en contrainte du filtre*

Des écarts matriciels sont appliqués aux matrices de transition et d'observation à chaque cycle de Kalman d'après un modèle de q axes non observables $\hat{v}_{1,k}(\hat{X}_{H,k})$, $\hat{v}_{2,k}(\hat{X}_{H,k})$, ...$\hat{v}_{q,k}(\hat{X}_{H,k})$ obtenus à chaque cycle k selon des fonctions de l'état global $\hat{X}_{H,k}$ correspondant au point de linéarisation de la matrice d'observation à la période de Kalman.

$\phi_{k \to k+1}(\hat{X}_{\phi,k})$ est remplacé par :

$$\phi_{k \to k+1}^{*}\left(\hat{X}_{\phi,k}, \hat{X}_{H,k}, \hat{X}_{H,k+1}\right) = \phi_{k \to k+1}\left(\hat{X}_{\phi,k}\right) + \delta\phi_{k \to k+1}\left(\hat{X}_{\phi,k}, \hat{X}_{H,k}, \hat{X}_{H,k+1}\right)$$ proche de $\phi_{k \to k+1}(\hat{X}_{\phi,k})$, et tel que pour i compris entre 1 et q :

**Equation 1 :** $\hat{v}_{i,k+1}\left(\hat{X}_{H,k+1}\right) = \phi_{k \to k+1}^{*}\left(\hat{X}_{\phi,k}, \hat{X}_{H,k}, \hat{X}_{H,k+1}\right)\hat{v}_{i,k}\left(\hat{X}_{H,k}\right)$, et $\left\|\delta\phi_{k \to k+1}\left(\hat{X}_{H,k}, \hat{X}_{H,k+1}\right)\right\|$

minimum vis-à-vis de toutes les solutions possibles.

$H_k(\hat{X}_{H,k})$ est remplacé par $H_k^{*}\left(\hat{X}_{H,k}\right) = H_k\left(\hat{X}_{H,k}\right) + \delta H_k\left(\hat{X}_{H,k}\right)$ proche de $H_k(\hat{X}_{H,k})$, et tel que pour i compris entre 1 et q :

**Equation 2 :** $H_k^{*}\left(\hat{X}_{H,k}\right)\hat{v}_{i,k}\left(\hat{X}_{H,k}\right) = 0$ , et $\left\|\delta H_k\left(\hat{X}_{H,k}\right)\right\|$

minimum vis-à-vis de toutes les solutions possibles.

La norme des matrices considérée est la norme de Froboenius.

Les matrices $\phi_{k\to k+1}^*\left(\hat{X}_{\phi,k},\hat{X}_{H,k},\hat{X}_{H,k+1}\right)$ et $H_k^*\left(\hat{X}_{H,k}\right)$ sont alors utilisées dans l'étape de propagation de la matrice de covariance, et du calcul du gain de Kalman.

On adopte désormais les notations suivantes : $\phi_{k\to k+1}^*\left(\hat{X}_{\phi,k},\hat{X}_{H,k},\hat{X}_{H,k+1}\right)$ est noté $\phi_{k\to k+1}^*$

$\delta\phi_{k\to k+1}(\hat{X}_{H,k},\hat{X}_{H,k+1})$ est noté $\delta\phi_{k\to k+1}$ $H_k^*\left(\hat{X}_{H,k}\right)$ est noté $H_k^*$ $\delta H_k(\hat{X}_{H,k})$ est noté $\delta H_k$

Résolution des équations 1 et 2 dans le cas où les vecteurs non observables modélisés $\hat{v}_{1,k},\hat{v}_{2,k},...\hat{v}_{q,k}$ sont orthogonaux entre eux à chaque instant k :

L'écart matriciel total de la matrice de transition correspond à la somme de q écarts matriciels indépendants. Il en est de même pour l'écart matriciel de la matrice d'observation.

$$\delta\phi_{k-1\to k} = \sum_{i=1}^{q}\delta\phi_{i,k-1\to k}$$

$$\delta H_k = \sum_{i=1}^{q}\delta H_{i,k}$$

Et, pour i compris entre 1 et q :

$$\delta\phi_{i,k-1\to k} = \frac{1}{\hat{v}_{i,k-1}^T\hat{v}_{i,k-1}}\left(\hat{v}_{i,k/k-1} - \phi_{k-1\to k}\hat{v}_{i,k-1}\right)\hat{v}_{i,k-1}^T$$

$$\delta H_{i,k} = -\frac{1}{\hat{v}_{i,k}^T\hat{v}_{i,k}}\left(H_k\hat{v}_{i,k}\right)\hat{v}_{i,k}^T$$

La démonstration de ces relations est donnée en annexe 8 selon une méthode géométrique.

Résolution des équations 1 et 2 pour une base non orthogonale, et pour q quelconque :

Cette base définit un modèle de l'espace vectoriel non observable : Toute combinaison linéaire des vecteurs de base est non observable.

L'image par la matrice d'observation ajustée de toute combinaison linéaire de ces vecteurs est donc nulle. Il est donc possible d'orthogonaliser la base, puis d'appliquer la méthode précédente pour calculer l'écart matriciel de la matrice d'observation.

D'autre part, l'image par la matrice de transition ajustée d'une combinaison linéaire de vecteurs non observables correspond à cette même combinaison linéaire appliquée aux images par la même matrice de transition de chacun des vecteurs non observables de départ. Il est donc possible de déterminer la combinaison linéaire permettant d'orthogonaliser la base de vecteurs non observables au cycle k-1, et d'utiliser cette même combinaison pour transformer le modèle de base non observable au cycle k. Cela permet d'appliquer la méthode précédente pour calculer l'écart matriciel de la matrice de transition.

*ANNEXE 4 : Métriques pondérées*

Des scalaires $m_\phi$ et $m_H$ appelés « métriques » accompagnent les matrices d'ajustement calculées et donnent une indication sur l'amplitude relative de l'ajustement, le but étant de modifier le plus faiblement possible les matrices de transition et d'observation.

Différentes méthodes sont possibles afin de comparer $\|\delta\phi_{k-1\to k}\|$ à $\|\phi_{k-1\to k}\|$, et $\|\delta H_k\|$ à $\|H_k\|$. Le but est de disposer d'une fonction croissante de $\dfrac{\|\delta\phi_{k-1\to k}\|}{\|\phi_{k-1\to k}\|}$ et $\dfrac{\|\delta H_k\|}{\|H_k\|}$ ou des constituants élémentaires $\dfrac{\|\delta\phi_{i,k-1\to k}\|}{\|\phi_{k-1\to k}\|}$ et $\dfrac{\|\delta H_{i,k}\|}{\|H_k\|}$, ces normes pouvant être calculées de la même façon que celle d'un vecteur en rassemblant tous les coefficients de la matrice en une seule colonne.

Des exemples sont donnés ci-dessous :

$$m_\phi = \frac{\|\delta\phi_{k-1\to k}\|}{\|\phi_{k-1\to k}\|} \quad \text{ou} \quad m_\phi = \left(\frac{\|\delta\phi_{k-1\to k}\|}{\|\phi_{k-1\to k}\|}\right)^2 \quad \text{ou} \quad m_\phi = \sum_{i=1}^{N} \frac{\|\delta\phi_{i,k-1\to k}\|}{\|\phi_{k-1\to k}\|}$$

$$m_H = \frac{\|\delta H_k\|}{\|H_k\|} \quad \text{ou} \quad m_H = \left(\frac{\|\delta H_k\|}{\|H_k\|}\right)^2 \quad \text{ou} \quad m_H = \sum_{i=1}^{N} \frac{\|\delta H_{i,k}\|}{\|H_k\|}$$

Des variantes sont possibles en faisant appel à des fonctions de pondération $g_\phi$ et $g_H$ pour équilibrer le poids des différentes composantes dans le calcul des normes de matrices. Les mêmes exemples que les précédents peuvent être repris en tenant compte de ces fonctions.

$$m_\phi = \frac{\|g_\phi(\delta\phi_{k-1\to k})\|}{\|g_\phi(\phi_{k-1\to k})\|} \quad \text{et} \quad m_H = \frac{\|g_H(\delta H_k)\|}{\|g_H(H_k)\|}$$

Par exemple :

Une réalisation possible de ces fonctions de pondération consiste à construire d'abord une fonction de pondération $f$ d'un vecteur d'état, puis d'en déduire $g_\phi$ et $g_H$.

Ainsi par cette méthode, au vecteur $U = [u_1\ u_2\ ...\ u_L]^T$ est associé par une fonction de pondération $f$ un vecteur $U' = f(U) = [a_1\ a_2\ ...\ a_L]\ U = [a_1 u_1\ a_2 u_2\ ...\ a_L u_L]^T$ où les coefficients réels $a_1,\ a_2, ... a_L$ forment les coefficients de pondération. Ces derniers permettent alors de pondérer la matrice de transition de la façon suivante :

$$g_\phi\left(\begin{bmatrix} t_{11} & t_{12} & ... & t_{1L} \\ t_{21} & t_{22} & & t_{2L} \\ ... & & ... & \\ t_{L1} & t_{L2} & & t_{LL} \end{bmatrix}\right) = \begin{bmatrix} \dfrac{a_1}{a_1}t_{11} & \dfrac{a_1}{a_2}t_{12} & ... & \dfrac{a_1}{a_N}t_{1L} \\ \dfrac{a_2}{a_1}t_{21} & \dfrac{a_2}{a_2}t_{22} & & \dfrac{a_2}{a_N}t_{2L} \\ ... & & ... & \\ \dfrac{a_L}{a_1}t_{L1} & \dfrac{a_L}{a_2}t_{L2} & & \dfrac{a_L}{a_L}t_{LL} \end{bmatrix}$$

Car si $V = \phi U$ alors $f(V) = g_\phi(\phi)f(U)$ et réciproquement. Ce sont 2 façons équivalentes d'écrire la relation entre U et V, la deuxième permettant de calculer des normes de façon équilibrée.

$$\phi = \begin{bmatrix} t_{11} & t_{12} & ... & t_{1L} \\ t_{21} & t_{22} & & t_{2L} \\ ... & & ... & \\ t_{L1} & t_{L2} & & t_{LL} \end{bmatrix},$$

En effet, en posant $U = [u_1\ u_2\ ...\ u_L]^T$ et $V = [v_1\ v_2\ ...\ v_L]^T$ On a

$$g_\phi(\phi)f(U) = \begin{bmatrix} \dfrac{a_1}{a_1}t_{11} & \dfrac{a_1}{a_2}t_{12} & \cdots & \dfrac{a_1}{a_L}t_{1L} \\ \dfrac{a_2}{a_1}t_{21} & \dfrac{a_2}{a_2}t_{22} & & \dfrac{a_2}{a_L}t_{2L} \\ \cdots & & \cdots & \\ \dfrac{a_L}{a_1}t_{L1} & \dfrac{a_L}{a_2}t_{L2} & & \dfrac{a_L}{a_L}t_{LL} \end{bmatrix} \begin{bmatrix} a_1 u_1 \\ a_2 u_2 \\ \cdots \\ a_L u_L \end{bmatrix} = \begin{bmatrix} a_1 t_{11} & a_1 t_{12} & \cdots & a_1 t_{1L} \\ a_2 t_{21} & a_2 t_{22} & & a_2 t_{2L} \\ \cdots & & \cdots & \\ a_L t_{L1} & a_L t_{L2} & & a_L t_{LL} \end{bmatrix} \begin{bmatrix} u_1 \\ u_2 \\ \cdots \\ u_L \end{bmatrix}$$

C'est-à-dire

$$g_\phi(\phi)f(U) = \begin{bmatrix} a_1 & a_2 & \cdots & a_L \end{bmatrix} \begin{bmatrix} t_{11} & t_{12} & \cdots & t_{1L} \\ t_{21} & t_{22} & & t_{2L} \\ \cdots & & \cdots & \\ t_{L1} & t_{L2} & & t_{LL} \end{bmatrix} \begin{bmatrix} u_1 \\ u_2 \\ \cdots \\ u_L \end{bmatrix} = \begin{bmatrix} a_1 & a_2 & \cdots & a_L \end{bmatrix}\phi U$$

Donc $g_\phi(\phi)f(U) = [a_1\ a_2\ \ldots\ a_L]V$

Donc $f(V) = g_\phi(\phi)f(U)$

$$g_H\left(\begin{bmatrix} t_{11} & t_{12} & \cdots & t_{1L} \\ t_{21} & t_{22} & & t_{2L} \\ \cdots & & \cdots & \end{bmatrix}\right) = \begin{bmatrix} \dfrac{1}{a_1}t_{11} & \dfrac{1}{a_2}t_{12} & \cdots & \dfrac{1}{a_L}t_{1L} \\ \dfrac{1}{a_1}t_{21} & \dfrac{1}{a_{22}}t_{22} & & \dfrac{1}{a_L}t_{2L} \\ \cdots & & \cdots & \end{bmatrix}$$

De façon similaire

*ANNEXE 5 : Notion de système dynamique et application à la navigation*

C'est un système d'équations déterministe comportant une équation d'évolution et une équation d'observation. L'équation d'évolution décrit un vecteur d'état en fonction de son état antérieur et d'une commande. L'équation d'observation fournit un scalaire ou vecteur dépendant du vecteur d'état. Ces équations peuvent être non linéaires. Il existe des systèmes à temps continu et des systèmes à temps discret.

Système à temps continu :
$$\begin{cases} \dot{X}(t) = f(X(t), u(t)) \\ z(t) = h(X(t)) \end{cases}$$

Système à temps discret :
$$\begin{cases} x_{k+1} = f(x_k, u_k) \\ z_k = h(x_k) \end{cases}$$
Où $X(t)$ et $x_k$ désignent l'état du système, $u(t)$ et $u_k$ désignent la commande d'entrée, $z(t)$ et $z_k$ désignent l'observation à un instant continu t ou instant discret k, selon le mode de représentation continu ou discret.

Les équations de la mécanique classique de Newton permettent de décrire l'état d'un repère mobile en fonction de son accélération et de sa vitesse angulaire à tout instant. Ces équations constituent un exemple de fonction d'évolution continue, le vecteur d'état rassemblant les informations de position, de vitesse, et d'orientation du repère mobile, et le vecteur de commande étant constitué de l'accélération et la vitesse angulaire.

Dans l'état de l'art d'une centrale inertielle de navigation, les calculs ne peuvent être réalisés que de façon discrète. Il en résulte que cette fonction d'évolution continue y est modélisée sous forme d'une fonction d'évolution discrète. Différentes méthodes connues permettent de convertir les équations d'évolution continues en équations d'évolution discrètes.

La fonction d'observation modélisée dans le système dynamique à temps discret de la centrale inertielle décrit les mesures effectuées par un capteur non inertiel particulier. Plusieurs fonctions d'observation peuvent alors être mises en oeuvre successivement dans le temps en fonction des capteurs utilisés.

Le système dynamique à temps discret utilisé dans la centrale inertielle de navigation est donc un modèle le plus fidèle possible d'un autre système dynamique, à temps continu, correspondant au monde vrai. Les propriétés d'observabilité de ces deux systèmes sont donc différentes.

Les propriétés d'observabilité d'un système dynamique caractérisent les informations sur l'état du système à un instant donné qui peuvent être obtenues en tenant compte des observations effectuées ultérieurement et des fonctions d'évolution et d'observation. Ces propriétés dépendent notamment de la commande, c'est-à-dire des mouvements du porteur dans le cas de la centrale inertielle de navigation.

*ANNEXE 6 : Observabilité d'un système à temps continu*

Considérons un système dynamique continu non linéaire qui, à l'instant 0 se trouve dans un état $X(0)$. Par la suite, la fonction de propagation ainsi que la commande d'entrée font passer le système dans des états $X(t)$, définissant ainsi une trajectoire particulière dans l'espace d'état.

Cette trajectoire étant connue, supposons que l'état initial s'écarte maintenant de $X(0)$ d'une petite valeur $\delta X(0)$ appelée état linéarisé et que les commandes d'entrée soient les mêmes que dans la situation précédente. Les états suivants sont alors $X(t)+\delta X(t)$. La fonction d'observation permet de recueillir à chaque étape des informations sur l'état courant. Le problème posé est de savoir si ces informations du début à la fin du scénario considéré permettent de connaître $\delta X(0)$. L'espace des états linéarisés à l'instant 0 est alors composé d'un sous-espace observable et un sous-espace non observable. L'espace non observable à l'instant 0 caractérisé par l'état $\delta X(0)$ peut alors se déduire d'après un nouveau système dynamique permettant de décrire les états linéarisés en connaissant la trajectoire $X(t)$ :

$$\begin{cases} \delta\dot{X}(t) = \dfrac{\partial f}{\partial X}\big(X(t),u(t)\big)\delta X(t) = F\big(X(t),u(t)\big)\delta X(t) \\ \delta z(t) = \left(\dfrac{dh}{dX}\right)_{X(t)} \delta X(t) = H\big(X(t)\big)\delta X(t) \end{cases}$$

où F et H sont des matrices variables dans le temps correspondant à la matrice d'évolution et la matrice d'observation du système dynamique linéarisé pour une trajectoire donnée.

L'espace non observable est alors constitué d'états linéarisés $\delta X(t)$ tels que $\dfrac{d^k z(t)}{dt^k} = 0$ pour $k=1,2,3,...$ et $t \geq 0$

Les solutions forment un espace vectoriel d'états linéarisés. Il existe alors une base $B(0)$ de cet espace formant des vecteurs non observables $B(0)=(\delta X_1(0),\delta X_2(0),...,\delta X_q(0))$ à l'instant 0.

*ANNEXE 7 : Observabilité d'un système à temps discret*

Considérons un système dynamique discret non linéaire qui, à l'instant 0 se trouve dans un état $X_0$. A différents instants discrets successifs, la fonction de propagation ainsi que la commande d'entrée font passer le système dans des états $X_1, X_2,...$ Connaissant ces états successifs, supposons que l'état initial s'écarte maintenant de $X_0$ d'une petite valeur $\delta X_0$ appelé état linéarisé et que les commandes d'entrée soient les mêmes que dans la situation précédente. Les états successifs suivants sont alors $X_1+\delta X_1, X_2+\delta X_2,...$ La fonction d'observation permet de recueillir à chaque étape des informations sur l'état courant. Le problème posé est de savoir si ces informations du début à la fin du scénario considéré permettent de connaître $\delta X_0$. L'espace des états linéarisés à l'instant 0 est alors composé d'un sous-espace observable et un sous-espace non observable. Un observateur fonctionnant sur le principe de la linéarisation, comme l'EKF ne pourra alors jamais estimer une erreur dans l'espace non observable des états linéarisés.

L'espace non observable à l'instant 0 caractérisé par l'état $X_0$ peut alors se déduire en considérant le système dynamique des états linéarisés $\delta X_k$, mettant en oeuvre la fonction d'évolution et la fonction d'observation linéarisées aux différents états $X_0,X_1,X_2,...$ La fonction d'évolution linéarisée à l'instant k est appelée « matrice de transition » notée $\phi_{k\to k+1}(X_k)$. La fonction d'observation linéarisée à l'instant k est notée $H_k(X_k)$.

Une première observation de l'écart $\delta X_0$ autour de $X_0$ est faite à l'aide de la matrice d'observation $H_0(X_0)$ correspondant à la fonction d'observation linéarisée en $X_0$. Une prédiction de l'écart $\delta X_1$ autour de $X_1$ est faite à partir de l'écart $\delta X_0$ autour de $X_0$ à l'aide de la matrice de transition $\phi_{0\to1}(X_0)$ correspondant à la fonction d'évolution linéarisée en $X_0$. Une deuxième observation de l'écart $\delta X_1$ autour de $X_1$ est faite à l'aide de la matrice d'observation $H_1(X_1)$, etc...

On sait alors que l'espace non observable du système décrivant la perturbation est le noyau de la matrice :

$$M(X_0) = \begin{bmatrix} H_0(X_0) \\ H_1(X_1)\phi_{0\to1}(X_0) \\ H_2(X_2)\phi_{1\to2}(X_1)\phi_{0\to1}(X_0) \\ \dots \end{bmatrix}$$

L'espace non observable et l'espace observable dépendent donc de l'état de référence initial $X_0$, de la commande d'entrée (données inertielles dans le cas des centrales inertielles), et des fonctions d'évolution et d'observation.

Supposons que le vecteur $v_0(X_0)$ fasse partie du noyau de $M(X_0)$.

Posons :
$$\begin{cases} v_1(X_1) = \phi_{0\to1}(X_0)v_0(X_0) \\ v_2(X_2) = \phi_{1\to2}(X_1)v_1(X_1) \\ v_3(X_3) = \phi_{2\to3}(X_2)v_2(X_2) \\ \dots \end{cases},$$

On a alors :
$$\begin{cases} H_0(X_0)v_0(X_0) = 0 \\ H_1(X_1)v_1(X_1) = 0 \\ H_2(X_2)v_2(X_2) = 0 \\ \dots \end{cases}$$

A un instant donné, une condition d'observabilité est alors formée pour une direction non observable par le système d'équations:

$$\begin{cases} v_{k+1}(X_{k+1}) = \phi_{k\to k+1}(X_k)v_k(X_k) \\ H_{k+1}(X_{k+1})v_{k+1}(X_{k+1}) = 0 \end{cases}$$

Où $v_k(X_k)$ forme un vecteur non observable particulier à un instant discret k.

Cette condition s'applique à chaque instant et est liée à la trajectoire $X_0$, $X_1$, $X_2$,...

Dans l'EKF, cette trajectoire est bruitée par les erreurs d'estimation. Ce bruit a tendance à réduire le noyau de la matrice d'observabilité, et donc à diminuer la dimension de l'espace non observable.

De plus les fonctions de transition et d'observation ne sont pas linéarisées au même point. La suite $X_0$, $X_1$, $X_2$,... est remplacée par une suite $\hat{X}_{H,0}$, $\hat{X}_{\phi,1}$, $\hat{X}_{H,1}$, $\hat{X}_{\phi,2}$, $\hat{X}_{H,2}$, $\hat{X}_{\phi,3}$,...

Et :
$$\begin{cases} v_1(X_{H,1}) = \phi_{0\to1}(X_{\phi,0})v_0(X_{H,0}) \\ v_2(X_{H,2}) = \phi_{1\to2}(X_{\phi,1})v_1(X_{H,1}) \\ v_3(X_{H,3}) = \phi_{2\to3}(X_{\phi,2})v_2(X_{H,2}) \\ \dots \end{cases},$$

Avec:
$$\begin{cases} H_0(X_{H,0})v_0(X_{H,0}) = 0 \\ H_1(X_{H,1})v_1(X_{H,1}) = 0 \\ H_2(X_{H,2})v_2(X_{H,2}) = 0 \\ \dots \end{cases}$$

La condition d'observabilité s'écrit alors :

$$\begin{cases} v_{k+1}(\hat{X}_{H,k+1}) = \phi_{k\to k+1}(\hat{X}_{\phi,k})v_k(\hat{X}_{H,k}) \\ H_{k+1}(\hat{X}_{H,k+1})v_{k+1}(\hat{X}_{H,k+1}) = 0 \end{cases}$$

*ANNEXE 8 : démonstration de la formule d'ajustement de matrices pour une base orthogonale de vecteurs*

Hypothèse : p matrices colonne $U_i$ telles que :

$$\boxed{\forall(i,j)\,\text{tq}\; i \neq j, U_i^T U_j = 0} \quad (1)$$

Soit p matrices colonne $V_i$ de même dimension que les $U_i$.

Soit la matrice A.

Problème : On recherche la matrice $\delta A$ de norme minimum telle que :

$$\boxed{(A + \delta A)(U_1 \quad U_2 \quad ... \quad U_q) = (V_1 \quad V_2 \quad ... \quad V_q)}$$

La matrice $A + \delta A$ peut se mettre sous forme de p matrices ligne en colonne, et les vecteur $V_k$ sous forme de q scalaires en colonne :

$$\begin{pmatrix} L_1 + \delta L_1 \\ L_2 + \delta L_2 \\ ... \\ L_p + \delta L_p \end{pmatrix}(U_1 \quad U_2 \quad ... \quad U_q) = \begin{pmatrix} v_{11} & v_{12} & ... & v_{1q} \\ v_{21} & v_{22} & & v_{2q} \\ ... & ... & & ... \\ v_{q1} & v_{q2} & ... & v_{qq} \end{pmatrix}$$

On recherche donc les $\delta L_k$ de norme minimum tels que :

$$\boxed{\forall (k,l) \in \{1,2,...,q\}^2, (L_k + \delta L_k)U_l = v_{kl}} \ (2)$$

Interprétation géométrique du problème : Les matrices ligne et colonne sont associées à des vecteurs dans un espace vectoriel de dimension supérieure à q. On garde les mêmes notations en ajoutant une flèche au-dessus des variables.

La condition (1) se traduit par : $\forall(i,j)tq \ i \neq j, \vec{U_i} \perp \vec{U_j}$

La condition (2) se traduit par le produit scalaire suivant :

$$\forall (k,l) \in \{1,2,...,q\}^2, (\vec{L_k} + \vec{\delta L_k}).\vec{U_l} = v_{kl}$$

La projection du vecteur $\vec{L_k}$ sur l'axe orienté défini par le vecteur unitaire $\dfrac{\vec{U_l}}{\|\vec{U_l}\|}$ a pour abscisse

$\vec{L_k}.\dfrac{\vec{U_l}}{\|\vec{U_l}\|} = \dfrac{\vec{L_k}.\vec{U_l}}{\|\vec{U_l}\|}$ sur cet axe. C'est le cosinus directeur de $\vec{L_k}$ selon cet axe.

On recherche $\vec{\delta L_k}$ tel que la projection de $\vec{L_k} + \vec{\delta L_k}$ sur cet axe soit $\dfrac{(\vec{L_k}+\vec{\delta L_k}).\vec{U_l}}{\|\vec{U_l}\|} = \dfrac{v_{kl}}{\|\vec{U_l}\|}.$

$\vec{\delta L_k}$ peut être décomposé selon les vecteurs $U_i$ qui génèrent un espace vectoriel de dimension q, et selon une composante résiduelle $\vec{\varepsilon_k}$ orthogonale à cet espace : $\boxed{\vec{\delta L_k} = \sum_{l=1}^{q} \vec{\delta L_{kl}} + \vec{\varepsilon_k}}$

Et donc $\dfrac{(\vec{L_k}+\vec{\delta L_{kl}}).\vec{U_l}}{\|\vec{U_l}\|} = \dfrac{v_{kl}}{\|\vec{U_l}\|}.$

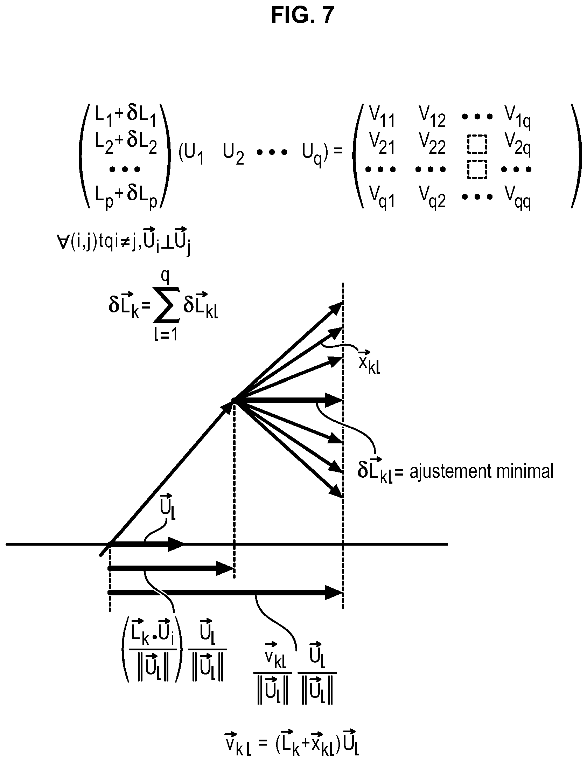

La figure 7 montre qu'il existe une infinité de solutions $\vec{x_{kl}}$. La solution minimale correspond à un vecteur $\vec{\delta L_{kl}}$ colinéaire à $\vec{U_l}$.

D'après la figure, on a :

$$\vec{\delta L_{kl}} = \frac{v_{kl}}{\|\vec{U_l}\|} \frac{\vec{U_l}}{\|\vec{U_l}\|} - \frac{\vec{L_k}.\vec{U_l}}{\|\vec{U_l}\|} \frac{\vec{U_l}}{\|\vec{U_l}\|}$$

$$\delta\vec{L}_{kl} = \left(\frac{v_{kl}}{\|\vec{U}_l\|} - \frac{\vec{L}_k.\vec{U}_l}{\|\vec{U}_l\|}\right)\frac{\vec{U}_l}{\|\vec{U}_l\|}$$

$$\delta\vec{L}_{kl} = \frac{1}{\|\vec{U}_l\|^2}\left(v_{kl} - \vec{L}_k.\vec{U}_l\right)\vec{U}_l$$

On a donc $\vec{\varepsilon}_k = \vec{0}$, et :

$$\delta\vec{L}_k = \sum_{l=1}^{q}\frac{1}{\|\vec{U}_l\|^2}\left(v_{kl} - \vec{L}_k.\vec{U}_l\right)\vec{U}_l$$

De retour en notation matricielle, on a donc :

$$\delta L_k = \sum_{l=1}^{q}\frac{1}{U_l^T U_l}\left(v_{kl} - L_k U_l\right)U_l^T$$

En reformant les matrices A et $\delta$A, après quelques manipulations, on obtient la relation :

$$\delta A = \sum_{l=1}^{q}\frac{1}{U_l^T U_l}\left(V_l - A U_l\right)U_l^T$$

## Revendications

1. Procédé d'estimation d'un état de navigation à plusieurs variables d'un porteur mobile selon la méthode du filtre de Kalman étendu, comprenant les étapes de :

   - acquisition de mesures d'au moins une des variables,
   - filtrage (400) de Kalman étendu produisant un état estimé courant et une matrice de covariance délimitant dans l'espace de l'état de navigation une région d'erreurs, à partir d'un état estimé précédent, d'une matrice d'observation ($\phi_{k-1\to k}$), d'une matrice de transition ($H_k$) et des mesures acquises,

   le procédé étant **caractérisé en ce qu'**il comprend une étape d'ajustement (310, 330) de la matrice de transition ($H_k$) et de la matrice d'observation ($\phi_{k-1\to k}$) avant leur utilisation dans le filtrage de Kalman étendu, de sorte que les matrices ajustées vérifient une condition d'observabilité qui dépend d'au moins une des variables de l'état du porteur, la condition d'observabilité étant adaptée pour empêcher le filtre de Kalman de réduire la dimension de la région le long d'au moins un axe non-observable de l'espace d'état, dans lequel la condition d'observabilité à vérifier par les matrices de transition et d'observation ajustées est la nullité du noyau d'une matrice d'observabilité ($M(X_0)$) qui leur est associée, et
   dans lequel l'ajustement comprend les étapes de :

   - calcul (301) d'au moins une base primaire $\left(B_k^1\right)$ de vecteurs non-observables à partir de l'état estimé précédent,
   - pour chaque matrice à ajuster ($H_k$, $\phi_{k-1\to k}$), calcul (306, 308) d'au moins un écart matriciel ($\delta H_k$, $\delta\phi_{i,k-1\to k}$) associé à la matrice à partir de la base primaire $\left(B_k^1\right)$ de vecteurs,

- décalage (330) de chaque matrice à ajuster ($H_k$, $\phi_{k-1 \rightarrow k}$) selon l'écart matriciel ($\delta H_k$, $\delta\phi_{i,k-1 \rightarrow k}$) qui lui est associé de sorte à vérifier la condition d'observabilité.

2. Procédé selon la revendication 1, dans lequel l'étape de filtrage de Kalman étendu comprend les sous-étapes de :

- propagation de l'état estimé précédent en un état prédit au moyen de la matrice de transition ajustée,
- linéarisation en l'état prédit d'un modèle non-linéaire pour produire la matrice d'observation ($\phi_{k-1 \rightarrow k}$) avant ajustement,
- ajustement de la matrice d'observation produite par linéarisation.

3. Procédé d'estimation selon l'une des revendications précédentes, comprenant en outre une étape d'orthogonalisation (302) de la base primaire $\left( B_k^1 \right)$ en une base secondaire $\left( B_k^2 \right)$ de vecteurs, l'écart matriciel ( $\delta\phi_{i,k-1 \rightarrow k}$) associé à la matrice d'observation ($\phi_{k-1 \rightarrow k}$) étant calculé à partir de la base secondaire $\left( B_k^2 \right)$ de vecteurs.

4. Procédé d'estimation selon l'une des revendications précédentes, dans lequel l'écart matriciel ($\delta\phi_{i,k-1 \rightarrow k}$) associé à la matrice d'observation est la somme de plusieurs écarts matriciels élémentaires ($\delta\phi_{i,k-1 \rightarrow k}$), chaque écart matriciel élémentaire ($\delta\phi_{i,k-1 \rightarrow k}$) étant calculé à partir d'un vecteur de la base secondaire $\left( B_k^2 \right)$ qui lui est propre.

5. Procédé d'estimation selon l'une des revendications précédentes dont les étapes sont répétées dans des cycles successifs, et dans lequel un cycle donné, dit cycle courant, comprend les étapes de:

- mémorisation (303) de la base secondaire $\left( B_k^2 \right)$ de vecteurs et de coefficients d'orthogonalisation qui sont également produits par l'étape d'orthogonalisation, et

- transformation (304) de la base primaire $\left( B_k^1 \right)$ de vecteurs en une base tertiaire $\left( B_k^3 \right)$ de vecteurs au moyen de coefficients d'orthogonalisation mémorisés au cours d'un cycle précédent,

le calcul (306) de l'écart matriciel associé à la matrice de transition étant mis en oeuvre à partir d'une base secondaire $\left( B_{k-1}^2 \right)$ mémorisée au cours du cycle précédent et de la base tertiaire $\left( B_k^3 \right)$ calculée au cours du cycle courant.

6. Procédé d'estimation selon la revendication précédente, dans lequel l'écart matriciel ($\delta H_k$) associé à la matrice de transition est la somme de plusieurs écarts matriciels élémentaires, chaque écart matriciel élémentaire ($\delta H_{i,k}$) étant calculé à partir d'un vecteur de la base secondaire $\left( B_{k-1}^2 \right)$ mémorisée au cours du cycle précédent et propre à l'écart matriciel élémentaire, et d'un vecteur de la base tertiaire $\left( B_k^3 \right)$ calculée au cours du cycle courant et propre à l'écart matriciel élémentaire ($\delta H_{i,k}$).

7. Centrale inertielle (IN) comprenant une pluralité de capteurs (CI, CC) et des moyens (E) pour estimer un état de navigation de la centrale inertielle par mise en oeuvre du procédé d'estimation selon l'une des revendications précédentes.

8. Produit programme d'ordinateur comprenant des instructions de code de programme pour l'exécution des étapes du procédé selon l'une des revendications 1 à 6, lorsque ce programme est exécuté par des moyens (E) de traitement de données.

**Patentansprüche**

1. Verfahren zur Schätzung eines Navigationszustands mit mehreren Variablen eines mobilen Trägers gemäß der Methode des erweiterten Kalman-Filters, die folgenden Schritte umfassend:

- Akquirieren von Messungen mindestens einer der Variablen,
- Erweiterte Kalman-Filterung (400), erzeugend einen geschätzten aktuellen Zustand und eine Kovarianzmatrix, welche im Raum des Navigationszustands aus einem vorherigen geschätzten Zustand eine Fehlerregion einer Beobachtungsmatrix ($\phi_{k-1\rightarrow k}$), einer Übergangsmatrix ($H_k$) und der akquirierten Messungen eingrenzt,

wobei das Verfahren **dadurch gekennzeichnet ist, dass** es einen Schritt zum Anpassen (310, 330) der Übergangsmatrix ($H_k$) und der Beobachtungsmatrix ($\phi_{k-1\rightarrow k}$) vor deren Verwendung in der erweiterten Kalman-Filterung umfasst, sodass die angepassten Matrizes eine Beobachtbarkeitsbedingung überprüfen, die von mindestens einer der Variablen des Zustands des Trägers abhängt, wobei die Beobachtbarkeitsbedingung geeignet ist, um zu verhindern, dass der Kalman-Filter die Dimension der Region entlang mindestens einer nicht beobachtbaren Achse des Zustandsraums zu reduzieren, in dem die durch die angepassten Übergangs- und Beobachtungsmatrizes zu überprüfende Beobachtbarkeitsbedingung die Nichtigkeit des Kerns einer Beobachtbarkeitsmatrix ($M(X_0)$) ist, die ihnen zugeordnet ist, und
in dem die Anpassung die folgenden Schritte umfasst:

- Berechnung (301) mindesten einer primären Basis ($B_k^1$) von nicht beobachtbaren Vektoren aus dem vorherigen geschätzten Zustand,
- für jede anzupassende Matrix ($Hk, \phi_{k-1\rightarrow k}$) Berechnung (306, 308) mindestens einer Matrixabweichung ($\delta H_k, \delta\phi_{i, k-1\rightarrow k}$), die der Matrix aus der primären Basis ($B_k^1$) an Vektoren zugeordnet ist,
- Verschiebung (330) jeder anzupassenden Matrix ($H_k, \phi_{k-1\rightarrow k}$) gemäß der Matrixabweichung ($\delta H_k, \delta\phi_{i, k-1\rightarrow k}$), die ihr zugeordnet ist, um die Beobachtbarkeitsbedingung zu überprüfen.

2. Verfahren nach Anspruch 1, wobei der Schritt der erweiterten Kalman-Filterung die folgenden Unterschritte umfasst:

- Ausbreitung des vorherigen geschätzten Zustands in einen vorhergesagten Zustand anhand der angepassten Übergangsmatrix,
- Linearisierung in den vorhergesagten Zustand eines nicht linearen Modells zum Erzeugen der Beobachtungsmatrix ($\phi_{k-1\rightarrow k}$) vor Anpassung,
- Anpassung der durch die Linearisierung erzeugten Beobachtungsmatrix.

3. Verfahren zur Schätzung nach einem der vorstehenden Ansprüche, darüber hinaus einen Schritt zur Orthogonalisierung (302) der primären Basis ($B_k^1$) in eine sekundäre Basis ($B_k^2$) von Vektoren umfassend, wobei die Matrixabweichung ($\delta\phi_{i, k-1\rightarrow k}$), die der Beobachtungsmatrix ($\phi_{k-1\rightarrow k}$) zugeordnet ist, aus der sekundären Basis ($B_k^2$) von Vektoren berechnet wird.

4. Verfahren zur Schätzung nach einem der vorstehenden Ansprüche, wobei die Matrixabweichung ($\delta\phi_{i, k-1\rightarrow k}$), die der Beobachtungsmatrix zugeordnet ist, die Summe mehrerer elementarer Matrixabweichungen ($\delta\phi_{i, k-1\rightarrow k}$) ist, wobei jede elementare Matrixabweichung ($\delta\phi_{i, k-1\rightarrow k}$) aus einem Vektor der sekundären Basis ($B_k^2$), der dieser eigen ist, berechnet wird.

5. Verfahren zur Schätzung nach einem der vorstehenden Ansprüche, dessen Schritte in aufeinanderfolgenden Zyklen wiederholt werden, und wobei ein gegebener Zyklus, der aktueller Zyklus genannt wird, die folgenden Schritte umfasst:

- Speichern (303) der der sekundären Basis ($B_k^2$) von Vektoren und von Orthogonalisierungs-Koeffizienten, die ebenfalls durch den Orthogonalisierungsschritt erzeugt werden, und
- Umwandeln (304) der primären Basis ($B_k^1$) von Vektoren in eine tertiäre Basis ($B_k^3$) von Vektoren anhand von im Laufe eines vorherigen Zyklus gespeicherten Orthogonalisierungs-Koeffizienten, wobei die Berechnung (306) der der Übergangsmatrix zugeordneten Matrixabweichung aus einer im Laufe des vorherigen Zyklus gespeicherten sekundären Basis ($B_{k-1}^2$) und der im aktuellen Zyklus berechneten tertiären Basis ($B_k^3$) umgesetzt wird.

6. Verfahren zur Schätzung nach dem vorstehenden Anspruch, wobei die der Übergangsmatrix zugeordnete Matrixabweichung ($\delta H_k$) die Summe mehrerer elementarer Matrixabweichungen ($\delta H_{i, k}$) ist, wobei jede elementare Matrixabweichung ($\delta H_{i, k}$) aus einem Vektor der im Laufe des vorhergehenden Zyklus gespeicherten sekundären Basis ($B_{k-1}^2$) berechnet wird und der elementaren Matrixabweichung eigen ist, und aus einem Vektor der im Laufe des vorhergehenden Zyklus berechneten tertiären Basis ($B_k^3$) und der elementaren Matrixabweichung ($\delta H_{i, k}$) eigen ist.

7. Inertialsystem (IN), eine Vielzahl von Sensoren (CI, CC) und Mittel (E) zur Schätzung eines Navigationszustandes des Inertialsystems durch Umsetzen eines Verfahrens zur Schätzung nach einem der vorstehenden Ansprüche umfassend.

8. Computerprogrammprodukt, Programmcodeanweisungen zur Ausführung der Schritte des Verfahrens nach einem der Ansprüche 1 bis 6 umfassend, wenn dieses Programm durch Mittel (E) zur Datenverarbeitung ausgeführt wird.

**Claims**

1. Method for estimating a navigation state with a plurality of variables of a mobile carrier according to the extended Kalman filter method, comprising the steps of:

   - acquiring measurements of at least one of the variables,
   - extended Kalman filtering (400) producing a current estimated state and a covariance matrix delimiting in the space of the navigation state a region of errors, from a preceding estimated state, an observation matrix ($\Phi_{k-1\to k}$), a transition matrix ($H_k$) and acquired measurements,

   the method being **characterised in that** it comprises a step of adjusting (310, 330) the transition matrix ($H_k$) and the observation matrix ($\Phi_{k-1\to k}$) prior to their use in the extended Kalman filtering, so that the adjusted matrices satisfy an observability condition that depends on at least one of the variables of the state of the carrier, the observability condition being adapted to prevent the Kalman filter from reducing the dimension of the region along at least one non-observable axis of the state space, wherein the observability condition to be satisfied by the adjusted transition and observation matrices is the nullity of the kernel of an observability matrix ($M(X_0)$) which is associated therewith, and
   wherein the adjustment comprises the steps of:

   - calculating (301) at least one primary base ($B^1{}_k$) of non-observable vectors from a preceding estimated state,
   - for each matrix to be adjusted ($H_k$, $\Phi_{k-1\to k}$), calculating (306, 308) at least one matrix difference ($\delta H_k$, $\delta\Phi_{k-1\to k}$) associated with the matrix from the primary base ($B^1{}_k$) of vectors,
   - offsetting (330) each matrix to be adjusted ($H_k$, $\Phi_{k-1\to k}$), according to the matrix difference ($\delta H_k$, $\delta\Phi_{k-1\to k}$) that is associated therewith so as to satisfy the observability condition.

2. Method according to Claim 1, in which the extended Kalman filtering comprises the sub-steps of:

   - propagating the preceding estimated state into a predicted state by means of the adjusted transition matrix,
   - linearising in the predicted state a non-linear model so as to produce the observation matrix ($\Phi_{k-1\to k}$), before adjustment,
   - adjusting the observation matrix produced by linearising.

3. Estimation method according to any one of the foregoing claims, also comprising a step of orthogonalizing (302) the primary base ($B^1{}_k$) into a secondary base ($B^2{}_k$) of vectors, the matrix difference ($\delta\Phi_{k-1\to k}$) associated with the observation matrix ($\Phi_{k-1\to k}$) being calculated from the secondary base ($B^2{}_k$) of vectors.

4. Estimation method according to any one of the foregoing claims, in which the matrix difference ($\delta\Phi_{i,x-1\to k}$) associated with the observation matrix is the sum of a plurality of elementary matrix differences ($\delta\Phi_{i,k-1\to k}$), each elementary matrix difference ($\delta\Phi_{k-1\to k}$) being calculated from a vector of the secondary base ($B^2{}_k$) particular thereto.

5. Estimation method according to any one of the foregoing claims, the steps whereof are repeated in successive cycles, and in which a given cycle, called current cycle, comprises the steps of:

   - storing (303) the secondary base ($B^2{}_k$) of orthogonalization vectors and coefficients, which are also produced by the orthogonalisation step, and
   - transforming (304) the primary base ($B^1{}_k$) of vectors into a tertiary base ($B^3{}_k$) of vectors by means of orthogonalization coefficients stored during a preceding cycle,

   the matrix difference associated with the transition matrix being calculated (306) from a secondary base ($B^2{}_{k-1}$) stored during the preceding cycle and the tertiary base ($B^3{}_k$) calculated during the current cycle.

6. Estimation method according to the foregoing claim, wherein the matrix difference ($\delta H_k$) associated with the transition matrix is the sum of a plurality of elementary matrix differences ($\delta H_{i,k}$), each elementary matrix difference ($\delta H_{i,k}$) being calculated from a vector of the secondary base ($B^2{}_{k-1}$) stored during the preceding cycle and specific to the elementary matrix difference, and from a vector of the tertiary base ($B^3{}_k$) calculated during the current cycle and specific to the elementary matrix difference ($\delta H_{i,x}$).

7. Inertial unit (IN) comprising a plurality of sensors (CI, CC) and means (E) for estimating a navigation state of the inertial unit by executing the estimation method according to any one of the foregoing claims.

8. Computer program product comprising program code instructions for execution of the steps of the method according to any one of claims 1 to 6, when this program is executed by data-processing means (E).

**FIG. 1**

Enveloppe 3 sigma de la loi estimée

O

Erreur nulle

Enveloppe 3 sigma de la vraie loi

**Temps T$_1$**

**Temps T$_2$**

**Temps T$_3$**

**Temps T$_4$**

**FIG. 2**

Axe non observable

Axe observable

Axe non observable

Axe observable

Axe non observable

Axe observable

Vraie

Estimée

Temps T1

**Temps T$_1$**

**Temps T$_2$**

Incohérence : réduction à tort selon l'axe non observable

**Temps T$_3$**

**Enveloppes d'erreurs dans l'espace d'état**

EP 3 213 033 B1

FIG. 3

EP 3 213 033 B1

**FIG. 4**

**FIG. 5**

EP 3 213 033 B1

**FIG. 6**

## FIG. 7

$$\begin{pmatrix} L_1+\delta L_1 \\ L_2+\delta L_2 \\ \bullet\bullet\bullet \\ L_p+\delta L_p \end{pmatrix} (U_1 \quad U_2 \quad \bullet\bullet\bullet \quad U_q) = \begin{pmatrix} V_{11} & V_{12} & \bullet\bullet\bullet & V_{1q} \\ V_{21} & V_{22} & \square & V_{2q} \\ \bullet\bullet\bullet & \bullet\bullet\bullet & \square & \bullet\bullet\bullet \\ V_{q1} & V_{q2} & \bullet\bullet\bullet & V_{qq} \end{pmatrix}$$

$$\forall (i,j) tq i \neq j, \vec{U}_i \perp \vec{U}_j$$

$$\delta \vec{L}_k = \sum_{l=1}^{q} \delta \vec{L}_{kl}$$

$$\vec{x}_{kl}$$

$$\delta \vec{L}_{kl} = \text{ajustement minimal}$$

$$\vec{U}_l$$

$$\left(\frac{\vec{L}_k \cdot \vec{U}_i}{\|\vec{U}_l\|}\right) \frac{\vec{U}_l}{\|\vec{U}_l\|}$$

$$\frac{\vec{v}_{kl}}{\|\vec{U}_l\|} \frac{\vec{U}_l}{\|\vec{U}_l\|}$$

$$\vec{v}_{kl} = (\vec{L}_k + \vec{x}_{kl}) \vec{U}_l$$

FIG. 8

EP 3 213 033 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014130854 A